# EUROPÄISCHE PATENTSCHRIFT

(11) **EP 4 416 758 B1**
(45) Veröffentlichungstag und Bekanntmachung des Hinweises auf die Patenterteilung: **26.11.2025**
(21) Anmeldenummer: 22803184.5
(22) Anmeldetag: 13.10.2022
(51) Int. Cl.: H01L 21/67, H01L 23/00, H01L 21/60

(54) **DIFFUSIONSLÖTVORRICHTUNG UND/ODER SINTERVORRICHTUNG, PRESSWERKZEUG UND ANLAGE ZUM VERBINDEN VON KOMPONENTEN ZUMINDEST EINER ELEKTRONISCHEN BAUGRUPPE**
DIFFUSION SOLDERING AND/OR SINTERING DEVICE, DIE AND SYSTEM FOR CONNECTING COMPONENTS OF AT LEAST ONE ELECTRONIC ASSEMBLY
DISPOSITIF DE BRASAGE PAR DIFFUSION ET/OU DISPOSITIF DE FRITTAGE, OUTIL ET INSTALLATION PERMETTANT DE RELIER DES COMPOSANTS D'AU MOINS UN MODULE ÉLECTRONIQUE

(30) Priorität: 14.10.2021 DE 102021126718
(43) Veröffentlichungstag der Anmeldung: 21.08.2024
(73) Patentinhaber: PINK GmbH Thermosysteme, 97877 Wertheim (DE)
(72) Erfinder: OETZEL, Christoph, 97896 Freudenberg Boxtal (DE)
(74) Vertreter: Spachmann, Holger
(86) Internationale Anmeldenummer: PCT/EP2022/078481
(87) Internationale Veröffentlichungsnummer: WO 2023/062116

(56) Entgegenhaltungen:
- WO-A1-2021/069328
- WO-A2-2017/137420
- DE-A1- 102007 047 698
- DE-A1- 102014 114 095
- DE-A1- 102017 216 545
- DE-A1- 102019 134 410
- DE-B4- 102014 114 093
- NL-B1- 2 015 895

## Beschreibung

Die vorliegende Erfindung betrifft eine Diffusionslötvorrichtung und/oder Sintervorrichtung zum Verbinden von Komponenten zumindest einer elektronischen Baugruppe mittels Diffusionslöten und/oder Drucksintern, mit einem Oberwerkzeug und einem Unterwerkzeug, zwischen denen die Baugruppe aufgenommen sind, wobei das Oberwerkzeug zumindest ein mit einem Fluid bzw. einem verdrängbaren Medium befülltes oder befüllbares Druckkissen, dessen Innendruck veränderbar ist und zumindest ein, insbesondere mehrere mit dem Druckkissen in Wirkverbindung stehende Stempel aufweist, welche zum Übertragen einer durch eine Druckerhöhung im Druckkissen erzeugten Presskraft auf die Baugruppe und von Wärmeenergie eingerichtet sind.

### STAND DER TECHNIK

Mit gattungsähnlichen Diffusionslöt- und/oder Sintervorrichtungen kann unter der Einwirkung von Hitze und Druck aus einem sogenannten Grünkörper, der aus einem fein- oder grobkörnigen Stoff oder Stoffgemisch besteht, ein festes Werkstück erzeugt werden. Die gattungsgemäße Diffusionslöt- und/oder Sintervorrichtung dient dazu, Komponenten von elektronischen Baugruppen mechanisch sowie elektrisch und thermisch leitend miteinander zu verbinden. Beispielsweise kann eine gattungsgemäße Diffusionslöt- und/oder Sintervorrichtung dazu verwendet werden, elektrische Halbleiterbauteile wie Hochleistungsschaltelemente oder Halbleiterbaugruppen und einen Grundkörper, beispielsweise eine Platine, einen Kühlkörper oder dergleichen, mittels Diffusionslöten oder Drucksintern miteinander zu verbinden. So hat sich im Bereich der Leistungselektronik etabliert, sogenannte Mold Module bereitzustellen, in denen verschiedene elektronische Schaltkreise und Halbleiterbauteile integriert werden können, und die in der Regel mit Kontaktpins für einen Anschluss an ein elektronisches System ausgerüstet sind. Diese Mold Module können der Verkapselung elektronischer Bauteile dienen, bei dem drahtgebondete, gelötete oder geklebte mikroelektronische Aufbauten mit einem thermomechanisch angepassten, robusten Verkapselungsmaterial geschützt werden können.

Beim Diffusionslöten erfolgt eine Vermischung von Atomen des festen Grundwerkstoffs mit Atomen des flüssigen Lotes unter Anwendung eines Pressdrucks. Dadurch entsteht eine Legierungszone die eine stoffschlüssige Verbindung zwischen Grundwerkstoff und Lot bildet. Bei einer Variante des Drucksinterns, dem Niedertemperatur-Drucksintern, können zwei oder mehr Bauelemente, insbesondere elektronische Bauelemente und Substrate, mittels eines Fügewerkstoffs miteinander elektrisch und/oder thermisch leitend verbunden werden, wobei hierbei der verbindende Fügewerkstoff gesintert wird. Eine entsprechende Vorrichtung und ein Verfahren sind beispielsweise aus WO 2014/135151 A2 bekannt.

Derzeit werden Verbindungsmethoden entwickelt, die eine Kombination eines Diffusionslötprozesses und eines Sinterprozesses darstellen, wobei die genutzten Verbindungsmittel eine Kombination aus einem Diffusionslot und einer Sinterpaste nutzen können.

Die erforderlichen Pressdrücke können bis zu 650 Bar betragen, angewendete Temperaturen von bis zu 350 °C sind möglich.

Gattungsgemäße Diffusionslöt- und/oder Sintervorrichtungen kommen häufig in automatischen Sinteranlagen, insbesondere automatischen Mehrkammer-Sinteranlagen, zum Einsatz.

Das Sintern oder Diffusionslöten der elektronischen Baugruppen selbst erfolgt dabei durch Temperierung der zu sinternden Baugruppen bzw. deren Komponenten und Einwirken eines durch das Ober- und Unterwerkzeug vermittelten Drucks. So beträgt beispielsweise die für die Verbindung und Diffusion beim Niedertemperatur-Drucksintern mit Silber erforderliche Temperatur regelmäßig zwischen ca. 130°C und 250°C bis 300°C und benötigt bei einem Druck bis maximal 30 MPa eine Zeitdauer von etwa 5 bis 10 Minuten.

Damit beim Drucksintern aus dem zwischen den Komponenten eingebrachten Sintermaterial zur Sicherstellung einer mechanisch stabilen, insbesondere scherfesten Verbindung und der gewünschten elektrischen und thermischen Leitfähigkeit eine möglichst geschlossenporige und parallele Schicht entsteht, wird die Fügeschicht vor und während des Diffusionsvorgangs durch Druck verdichtet. Zum Ende des Sintervorgangs werden der Druck und die Temperatur gesenkt.

Eine Herausforderung besteht darin, die zum Diffusionslöten oder Sintern erforderliche Presskraft auf die Baugruppen in möglichst gleichmäßiger Weise aufzubringen, so dass die Komponenten der Baugruppen keinen lokalen oder temporären Druckspitzen ausgesetzt sind. Besonders anspruchsvoll ist die Vermeidung von derartigen lokalen Druckspitzen beim Diffusionslöten oder Sintern von Baugruppen, bei denen mehrere elektronische Bauteile unterschiedlicher Höhe auf einem Substrat oder Werkstückträger angeordnet sind. Als elektronische Bauteile soll im Rahmen der Erfindung sowohl Halbleiterbauteile und elektronische Schaltgruppen, als auch passive elektrische Bauteile wie Kühlelemente wie Kühlplatten, Platinen (PCBs) oder Anschlusselemente, wie z.B. Powerpins, z.B. Kupferpins verstanden werden. Eine Baugruppe ist ein derartiges Bauteil oder eine Verbindung derartiger elektronischer Bauteile miteinander.

Im Nachfolgenden wird zumeist von Drucksintern gesprochen, dennoch sind auch alle Aspekte des Diffusionslöten gemeint, die bzgl. Temperatur- und Druckbeaufschlagung im Fügeprozess gleichartig bzw. ähnlich wie in einem Drucksinterverfahren umsetzbar sind.

Um eine möglichst gleichmäßige Verteilung der Presskraft oder des Pressdrucks zu ermöglichen, wurde im Stand der Technik vorgeschlagen, zur Pressdruckerzeugung Druckkissen zu verwenden, die mit mehreren Stempeln unterschiedlicher Höhe in Wirkverbindung stehen und welche die Presskraft vom Druckkissen auf die Baugruppen übertragen.

Eine derartige gattungsgemäße Sintervorrichtung ist in DE 10 2007 047 698 B4 beschrieben. Eine weitere Sintervorrichtung mit einem Druckkissen, jedoch ohne Stempel, ist in DE 102014 114 095 B4 offenbart.

Die EP 3 454 364 A1 betrifft Vorrichtungen zum Verkapseln oder Versintern von Halbleiterelementen und zeigt ein Oberwerkzeug und ein Unterwerkzeug mit einer dazwischen angeordneten Baugruppe. Das Oberwerkzeug zeigt eine Druckaufbringeinheit als ein mit einem Fluid befüllbares Druckkissen mit veränderbarem Innendruck, welches mit als Spacer bezeichneten Stempeln zum Übertragen der durch Druckerhöhung im Druckkissen erzeugten Presskraft auf die Baugruppe zusammenwirkt. Das Oberwerkzeug weist einen Führungsrahmen mit Führungskanälen auf, in welchen die Stempel axial entlang der Presskraft mit seitlichem Kippspiel versetzbar sind. Das Druckmedium ist in einer Druckkammer vorgesehen, wobei ein Diaphragma als flexible Membran zwischen dem Druckmedium und den Stempeln vorgesehen ist, welche die Führungskanäle überdeckt um die Führungskanäle der Stempel gegenüber dem Druckkissen abzudichten. Die Druckkammer ist mit einer Zufuhr für Fluid verbunden, um eine Druckerhöhung zu bewirken.

In der WO 2018/122 795 A1 ist eine gattungsgleichen Sintervorrichtung dargestellt, wobei Stempel hier direkt in einem Zylinder ohne angeordnet sind, so dass auf einem separaten Führungsrahmen verzichtet wird.

In der DE 10 2017 216 545 A1 ist eine Sintervorrichtung mit einem Oberwerkzeug und einem Unterwerkzeug für das Sintern elektronischer Baugruppe dargestellt. Ein Drucckissen umfasst einen Hohlraum und eine Membran und wird über eine Fluidquelle mit veränderbarem Innendruck beaufschlagt. Das Druckkissen steht über die Membran mit Pressstempel zum Übertragen der Presskraft in Verbindung, die in einem Führungsrahmen GE axial geführt sind.

Die WO 2016/050 466 A1 betrifft eine gattungsähnliche Sintervorrichtung, wobei in einer Zylinder-Kolben-Anordnung eine Aufnahme für ein Druckkissen vorgesehen ist.

Ein Nachteil von herkömmlichen Diffusionslöt- oder Sintervorrichtungen besteht darin, dass oftmals der Pressdruck bzw. die Presskraft nicht gleichmäßig und nicht parallel genug auf die zu sinternden bzw. diffusionslötenden Baugruppen ausgeübt werden kann. Es können Druckspitzen oder auch Druckgradienten sowie parallele Sinterschichten entstehen, welche lokal einzelne Komponenten belasten oder die Ausbildung von gleichmäßigen Fügeschichten, die an jedem Punkt die gleichen mechanischen, elektrischen und/oder thermischen Eigenschaften aufweisen, verhindert. Ein weiterer Nachteil von bekannten Diffusionslöt- oder Sintervorrichtungen kann darin bestehen, dass der Aufbau der Presskraft nicht gleichzeitig und nicht parallel erfolgt, d.h. es kann geschehen, dass der Pressdruck in bestimmten Bereichen früher aufgebaut wird als in anderen Bereichen, so dass die Pressdauer räumlich variieren kann, was eine kontrollierte Prozessführung erschwert und damit auch Qualitätsschwankungen zur Folge haben kann. Daneben ist ein Nachteil herkömmlicher Diffusionslöt- oder Sintervorrichtungen, die geführte Pressenstempel aufweisen, dass aufwändige Dichtmembranen oder Abdichtungen zu einem Druckraum oder einem Druckkissen vorgesehen werden müssen, die verschleißanfällig sind und die kein schnelles und kostengünstiges Umrüsten des Pressenwerkzeugs erlauben.

### BESCHREIBUNG DER ERFINDUNG

Es ist die Aufgabe der Erfindung, eine Diffusionslöt- und/oder Sintervorrichtung anzugeben, welche zum Erzeugen einer räumlich und zeitlich homogenen Presskraft auf zumindest eine, insbesondere eine Mehrzahl von Baugruppen eingerichtet ist.

Die Lösung der Aufgabe erfolgt durch eine Diffusionslöt- und/oder Sintervorrichtung mit den Merkmalen des Anspruchs 1. Vorteilhafte Ausführungsformen der Diffusionslöt- und/oder Sintervorrichtung sind in den Unteransprüchen angegeben.

Die vorliegende Erfindung sieht vor, dass das Oberwerkzeug einen Führungsrahmen aufweist, in welchem der oder die die Stempel axial entlang der Wirkrichtung der Presskraft versetzbar geführt sind. Der oder die Stempel sind in dem Führungsrahmen gegenüber dem Druckkissen abgedichtet versetzbar geführt Somit dichtet der Führungsrahmen und der oder die darin geführten, abgedichteten Stempel das Druckkissen gegenüber der Pressfläche ab und verhindert eine Beschädigung des Druckkissens. Durch die axiale Führung des oder der Stempel wird sichergestellt, dass die für das Diffusionslöten oder Drucksintern erforderliche Presskraft mit der erforderlichen Homogenität sowohl in räumlicher als auch in zeitlicher Hinsicht vom Druckkissen auf die zu sinternden oder zu verlötenden Baugruppe übertragen wird. Der oder die Stempel können beheizbar sein, bzw. ermöglichen eine schnelle Übertragung von Wärmeenergie auf die zu sinternde oder zu verlötenden Baugruppe. Die Übertragung kann jedenfalls selektiv und schneller erfolgen, als dies bisher bei einem großflächigen Einzelstempeln, insbesondere bei einem Einzelstempel mit einem Druckkissen, insbesondere Silikonkissen möglich ist. Der oder die Stempel sind demnach in oder entgegengesetzt zu der Wirkrichtung der Presskraft versetzbar geführt. Dabei können der oder die Stempel zumindest durch Ihre Geometriegestaltung selektiv einstellbare Presskräfte ausüben und sind unmittelbar miteinander mechanisch verkoppelt.

Die Abdichtung kann entweder durch eine, zwischen Druckkissen und Führungsrahmen bzw. der Oberseite des Stempels bzw. der Stempel, abdichtende Membran, oder durch ein Dichtungselement des oder der Stempel innerhalb der Stempelführung in dem Führungsrahmen erfolgen.

Das Druckkissen umfasst bevorzugt ein Volumen, das von einer flexiblen, biegsamen und/oder dehnbaren Kissenmembran umgrenzt wird, und das mit einem inkompressiblen oder kompressiblen Fluid oder einem verdrängbaren Medium wie einem Gel oder ähnliches gefüllt ist. Das Fluid bzw. das verdrängbare Medium kann im Druckkissen vorhanden sein, und/oder von außen vor oder während eines Diffusionslöt- und/oder Sintervorgangs zuführbar bzw. nachfüllbar sein, beispielsweise in Form einer hydraulischer Zufuhr. Bei dem in dem Volumen des Druckkissens aufgenommenen ausgleichenden Medium kann es sich üblicherweise ein Fluid oder ein anderes viskoses Medium, d. h. einem verdrängbaren Stoff, wie einem Elastomer handeln, beispielsweise Silikon, Thermalöl, Wärmeleitpaste oder Wärmeleitfett. Als Fluid kann beispielsweise Hydrauliköl, aber auch Silikon oder Perfluorpolyether (PFPE) genutzt werden. So weist das als Galden HS260 bezeichnete PFPE einen Siedepunkt von 260 °C auf, und kann beispielsweise im Falle einer Leckage des Druckkissens mittels einer regelmäßig vorhandenen Vakuumpumpe abgepumpt werden.

Ebenfalls kann das Druckkissen mit Gas oder Pulver befüllt sein, oder beispielsweise in Folienform ausgestattet sein, wie eine Graphitfolie oder kann als ein weiches Metall ausgeführt sein, insbesondere weicher als Eisen, beispielsweise Aluminium, Blei, Gold, Indium, Kupfer, Platin, Silber, Zink oder Zinn. Eine dünne elastische Folie wie Graphitfolie kann auch zur Herstellung einer Parallelität zwischen Oberstempel und Unterstempel genutzt werden. Grundsätzlich kann es sich bei dem Fluid auch um ein Gas, beispielsweise Stickstoff, handeln. Weiterhin ist auch die Verwendung von anderen gasförmigen Substanzen, insbesondere auch Wasserdampf, möglich. So kann das Fluid bevorzugt ein Gas oder ein anderes verdrängbares Medium sein, und beispielsweise PFPE (Galden), Silikon, CO₂, Argon, Stickstoff, Helium, Igumix (einem Gasgemisch) und Gemische oder Kombinationen aus Elastomeren, Ölen, Fetten und / oder Gasen sein. Das Volumen kann in sich abgeschlossen sein oder auch einen Zugang haben, über den Fluid zu- oder abgeführt werden kann, was nachfolgend im Zusammenhang mit einer bevorzugten Ausführungsform beschrieben ist.

Bevorzugt kann das Druckkissen als Silikonkissen ausgebildet sein.

Gemäß einer vorteilhaften Ausführungsform der Erfindung weist das Oberwerkzeug zumindest eine Druckeinheit mit einer Aufnahme für das Druckkissen auf. Die Aufnahme, die das Druckkissen, bevorzugt von mehreren Seiten umschließt, hält das Kissen sowohl in einer Arbeitsposition als auch in einer Ruheposition, in welcher keine Presskraft auf die Baugruppe ausgeübt wird und gewährleistet mit einer stabilen Abstützung für das Druckkissen eine Homogenisierung der Presskraft. Es können mehrere Druckeinheiten vorgesehen sein, insbesondere wenn jede Druckeinheit ein Druckkissen für einen Einzelstempel aufnimmt, wobei jeder Einzelstempel eine verhältnismäßig große Stempelfläche, wie dies z.B. bei Softstempeln der Fall ist, aufweist. Softstempel sind im Gegensatz zu Hartstempeln bestehen auf der Stempelfläche aus einem weichen Material wie Silikon oder einem weichen Metall.

Gemäß einer weiteren vorteilhaften Ausführungsform weist die Druckeinheit eine dem Unterwerkzeug zugewandte Öffnung auf, welche von dem Führungsrahmen überdeckt wird, wobei das Druckkissen auf dem Führungsrahmen aufliegt. Die Öffnung ermöglicht somit, dass das Druckkissen mit dem bzw. den in dem Führungsrahmen geführten Stempeln in Wirkverbindung treten kann. Zugleich stellt der Führungsrahmen eine weitere Abstützung bereit, welche die Abstützung durch die Aufnahme in der Druckeinheit ergänzt.

Gemäß einer weiteren vorteilhaften Ausführungsform weist die Druckeinheit einen Zylinder und einen darin versetzbar aufgenommenen Kolben auf, wobei der Zylinder und der Kolben die Aufnahme für das Druckkissen derart definieren, dass durch ein Versetzen des Kolbens das Volumen der Aufnahme veränderbar ist. So führt ein Eintauchen des Kolbens in den Zylinder zu einer Verkleinerung des Volumens der Aufnahme, wodurch der in dem Druckkissen herrschende Druck erhöht wird. Diese Druckerhöhung erzeugt die für das Diffusionslöten oder Drucksintern erforderliche Presskraft. Der Zylinder kann zugleich als Führungsrahmen dienen, sofern ein Einzelstempel oder ein sogenannter Multistempel, wie weiter unten erläutert, eingesetzt wird.

Wenn sich der Kolben aus dem Zylinder hinausbewegt, vergrößert sich das Volumen der Aufnahme wieder und der in dem Druckkissen herrschende Druck fällt ab, wodurch die Presskraft reduziert wird.

In dem Zusammenhang ist es bevorzugt, wenn die Öffnung in dem Kolben vorgesehen ist. Der Kolben befindet sich somit an einer dem Unterwerkzeug zugewandten Seite der Druckeinheit und ist beispielsweise als Ringkolben ausgebildet.

Gemäß einer weiteren vorteilhaften Ausführungsform sind das Oberwerkzeug und das Unterwerkzeug relativ zueinander entlang der Wirkrichtung der Presskraft versetzbar, wobei der Kolben bei einem Aufsetzen des Oberwerkzeugs auf dem Unterwerkzeug oder auf einem auf dem Unterwerkzeug aufliegenden Werkstückträger in den Zylinder hineinversetzt wird. Die Presskraft wird bei dieser Ausgestaltung in indirekter Weise erzeugt, nämlich durch eine Relativbewegung zwischen dem Oberwerkzeug und dem Unterwerkzeug. Diese Relativbewegung kann durch geeignete Mittel, beispielsweise durch Hydraulik- oder Spindelantriebe erfolgen. Das Versetzen des Kolbens relativ zum Zylinder erfolgt demnach indirekt oder passiv, ein direkter Antrieb, welcher diese Relativbewegung zwischen Kolben und Zylinder bewirkt, ist nicht erforderlich. Der Kolben ist bevorzugt mit dem Führungsrahmen verbunden. Somit erfolgt die Druckerhöhung in dem Druckkissen erst dann, wenn das Oberwerkzeug mit dem Unterwerkzug oder einem darauf gelagerten Werkstückträger, welcher die zu sinternden elektronischen Baugruppen trägt, in Kontakt tritt.

Gemäß einer weiteren vorteilhaften Ausführungsform der Erfindung ist das Druckkissen mit einer Fluidquelle zur Zufuhr von Fluid in das Druckkissen verbunden oder verbindbar, wobei die Druckerhöhung durch die Zufuhr von Fluid bewirkbar ist. Das Fluid kann eine Flüssigkeit oder ein Gas sein. Die Fluidquelle kann beheizbar- und / oder kühlbar sein, so dass das zugeführte Fluid zur Heizung und Kühlung nutzbar ist. Insbesondere kann die Fluidquelle einen Wärmetauscher, insbesondere einen Durchlaufwärmetauscher zur Temperierung des Fluids umfassen. Denkbar ist, dass als Fluid auch flüssiges Metall eingesetzt wird. Fluide bzw. verdrängbare Metalle können beispielsweise heißflüssig eingegossen werden, danach Erstarren und nach dem Einbau in die Sinteranlage über eine Heizung der Sinteranlage verflüssig werden und so flüssig bleibt bzw. verflüssigt werden. Beispielsweise kann hierzu Lötzinn passend zur Sinterprozesstemperatur eingesetzt werden.

Alternativ oder auch zusätzlich zu der vorstehend beschriebenen Veränderung des Volumens der Aufnahme durch ein Versetzen des Kolbens in den Zylinder kann demnach die Druckerhöhung in dem Druckkissen auch dadurch erfolgen, dass weiteres Fluid dem Druckkissen zugeführt wird. Bei der Fluidquelle kann es sich beispielsweise um eine Pumpe handeln oder ein sonstiges geeignetes Reservoir für Fluid, das geeignet ist, die Fluidzufuhr zu bewirken. Das Fluid kann in flüssiger oder gasförmiger Gestalt vorliegen, so bietet sich beispielsweise PFPE (Galden) als Fluid an, das sowohl flüssig als auch gasförmig vorteilhaft als Druckhomogenisierungsfluid nutzbar ist. Falls die Fluidquelle zusätzlich zu der vorstehend beschriebenen Zylinder-/Kolbenanordnung vorgesehen ist, kann die Zufuhr von Fluid in das Druckkissen eine weitere Druckerhöhung bewirken, selbst wenn ein weiteres Versetzen des Kolbens in den Zylinder hinein nicht mehr möglich oder erwünscht ist, beispielsweise, weil eine mechanische Begrenzung des Versetzweges wirksam geworden ist.

Vorzugsweise kann sowohl in flüssiger, aber je nach Temperaturbereich auch in gasförmiger Form als Fluid PFPE eingesetzt werden, und kann sowohl zur Wärmeübertragung als auch zum Druckausgleich eingesetzt werden. PFPE ist eine Gruppe von bei Raumtemperatur üblicherweise flüssigen bis pastösen Kunststoffen, Insbesondere wird beim Dampfphasenlöten ein Perfluorpolyether mit einem Siedepunkt von z.B. 260°C, verwendet, der auch als Galden HS260 (HS260 = 260 °C Siedepunkt) bezeichnet wird. Ein entscheidender Vorteil gegenüber Thermalölen ist das beim Bruch oder einer Undichtheit einer Membran des Druckkissens das austretende Fluid unschädlich für die Bauteile ist. Zudem kann in einer Vakuumkammer ist das Fluid mittels Vakuum verdampft werden und aus der Kammer über die Vakuumpumpe abgepumpt werden.

Gemäß einer weiteren vorteilhaften Ausführungsform umfasst der Führungsrahmen eine Stempelführungsplatte, welche Führungskanäle zur axialen Führung des Stempels bzw. der Stempel aufweist. Die Führungskanäle erstrecken sich bevorzugt in Wirkrichtung der Presskraft zumindest durch die Stempelführungsplatte hindurch und gewährleisten eine seitliche Führung des Stempels bzw. der Stempel, so dass hierdurch eine exakte Positionierung des Stempels bzw. der Stempel relativ zu den Komponenten der Baugruppe möglich ist. Die Stempelführungsplatte kann einteilig oder auch zwei- oder mehrteilig ausgebildet sein.

Gemäß einer weiteren vorteilhaften Ausführungsform ist zwischen dem Druckkissen und dem Stempel bzw. den Stempeln zumindest eine flexible Membran angeordnet. Die Membran dient hier als eine Art zusätzliche mechanische Schutzschicht und verhindert insbesondere, dass das Druckkissen durch lokale Druckspitzen bei der Druckbeaufschlagung der Stempel ungewollt beschädigt wird.

In dem Zusammenhang hat es sich als vorteilhaft erwiesen, wenn die Membran die Führungskanäle überdeckt. Hierbei wird insbesondere verhindert, dass das Druckkissen in Spalte hineingedrückt, die unter Umständen zwischen dem Stempel bzw. den Stempeln und Wandungen der Führungskanäle vorhanden sein können. Dadurch wird sichergestellt, dass die Druckerhöhung in dem Druckkissen vollumfänglich zur Erzeugung der auf die Wirkungsquerschnitte der Pressstempel einwirkenden Presskräfte zur Verfügung steht und nicht zu lokalen Ausstülpungen des Druckkissens in eventuelle Spalte oder Zwischenräume führt.

Gemäß einer weiteren vorteilhaften Ausführungsform weist der Führungsrahmen eine Membranhalteplatte auf, welche auf einer dem Druckkissen zugewandten Seite der Stempelführungsplatte angeordnet ist, wobei die Membran zwischen der Membranhalteplatte und der Stempelführungsplatte gehalten ist. Die Membranhalteplatte fixiert somit die Membran auf der Stempelführungsplatte und sorgt insbesondere auch für eine zusätzliche Vorspannung der Membran.

In dem Zusammenhang hat es sich als vorteilhaft erwiesen, wenn die Membranhalteplatte zumindest eine Durchbrechung aufweist, welche sich zumindest über die Führungskanäle erstreckt. Die Durchbrechung kann als eine große zentrale Durchbrechung ausgestaltet sein, welche die Stempelführungsplatte nur in ihrem Umfangsbereich überdeckt und dort die Membran zwischen der Membranhalteplatte und der Stempelführungsplatte fixiert. Bevorzugt weist die Membranhalteplatte jedoch mehrere separate Durchbrechungen auf, wobei jede Durchbrechung einem einzelnen oder bevorzugt einer Gruppe von Führungskanälen zugeordnet ist. Insbesondere kann die Größe und Anordnung der Durchbrechungen mit einer Größe und Anordnung eines zugeordneten Substrats korrespondieren, mit welchem elektronische Komponenten durch den Diffusionslötvorgang oder Drucksintervorgang verbunden werden sollen. Die Führungskanäle werden demnach nicht durch massive Abschnitte der Membranhalteplatte überdeckt, damit der bzw. die Stempel über die Membran mit dem Druckkissen in Wirkverbindung treten können.

Gemäß einer weiteren vorteilhaften Ausführungsform sind der bzw. die Stempel dauerhaft oder lösbar mit der Membran verbunden, bevorzugt verklebt. Durch die Verbindung zwischen dem Stempel bzw. den Stempeln und der Membran wird gewährleistet, dass der bzw. die Stempel nicht nach unten aus dem Führungsrahmen herausfallen können, wenn sich die Diffusionslöt- und/oder Sintervorrichtung in einer Ruhestellung befindet, bei welcher das Oberwerkzeug von dem Unterwerkzeug beabstandet ist.

Gemäß einer weiteren vorteilhaften Ausführungsform weist das Oberwerkzeug zumindest eine Sicherungsvorrichtung für den bzw. die Stempel auf, welche den bzw. die Stempel gegen ein Herausfallen der Stempel aus den Führungskanälen sichert.

In dem Zusammenhang hat es sich als vorteilhaft erwiesen, wenn die Membran magnetisch ist und die Sicherungsvorrichtung jeweilige mit dem bzw. den Stempeln verbundene, bevorzugt in den bzw. die Stempel integrierte Magnetelemente umfasst, welche den bzw. die Stempel an der Membran halten. Hierdurch werden also die Magnetelemente abnehmbar oder lösbar an der Membran gehalten. Dies hat den Vorteil, dass sowohl der bzw. die Stempel als auch die Membran wiederverwendbar sind, wenn die Diffusionslöt- und/oder Sintervorrichtung an andere Baugruppen angepasst werden müssen, die gegenüber den zuvor bearbeiteten Baugruppen Komponenten mit unterschiedlichen Abmessungen, insbesondere einer unterschiedlichen Höhe, aufweisen. Gegenüber fest verklebten Stempeln besteht hier insbesondere der Vorteil, dass gegebenenfalls nur ein Teil der Stempel ausgetauscht werden muss. Dies reduziert die Rüstzeiten und -kosten. Die magnetische Membran kann Bestandteil der Sicherungsvorrichtung sein. Auch ermöglichen die Magnetelemente eine einfache Neukonfigurierung im Sinne eines Schnellwechselsystems des bzw. der Stempel, die geänderten Baugruppenkonfigurationen angepasst werden können. So ist eine einzelne oder eine Mehrzahl von Baugruppen regelmäßig in einem Werkstückträger angeordnet, der im Bearbeitungsprozess durch die Diffusionslöt- und/oder Sintervorrichtung geführt wird. Beim Wechsel der Baugruppentypen bzw. der Anordnung im Werkstückträger ist eine Neukonfiguration der Stempelanordnung notwendig. Dies wird durch ein Schnellwechselsystem, insbesondere unter Verwendung von Magnetelementen, nachhaltig vereinfacht und kostengünstig.

Gemäß einer alternativen Ausführungsform umfasst die Sicherungsvorrichtung jeweilige Sicherungsstifte, welche in der Stempelführungsplatte gelagert sind und sich durch in den Stempeln vorgesehene Ausnehmungen hindurch erstrecken. Bei dieser Ausgestaltung kann ebenfalls ein Austausch des bzw. der Stempel realisiert werden. Die Sicherungsstifte weisen bevorzugt so viel Spiel in den Ausnehmungen auf, dass die erforderliche axiale Versetzbarkeit der Stempel für den Diffusionslötvorgang und/oder Sintervorgang gewährleistet ist. Hierzu können die Ausnehmungen beispielsweise als Langloch ausgebildet werden. Die Sicherungsstifte erstrecken sich mit ihrer Längsachse bevorzugt innerhalb einer durch die Haupterstreckungsrichtung der Stempelführungsplatte definierten Ebene. In der Stempelführungsplatte können entsprechende Lagerausnehmungen oder Nuten für die Sicherungsstifte ausgebildet sein, beispielsweise in Form von eingebrachten Vertiefungen. Um eine Montage und/oder einen Austausch der Stempel bzw. der Sicherungsstifte vornehmen zu können, kann die Stempelführungsplatte zweiteilig mit einer oberen und einer unteren Stempelführungsplatte ausgestaltet sein.

Gemäß einer weiteren vorteilhaften Ausführungsform der Erfindung sind den bzw. die Stempel mit seitlichem Spiel in den Führungskanälen aufgenommen. Sollten aufgrund von Fertigungstoleranzen die Kontaktflächen zwischen den zu sinternden Komponenten und den Stempeln nicht exakt parallel verlaufen, so ermöglicht das seitliche Spiel des bzw. der Stempel in den Führungskanälen ein geringfügiges Verkippen des bzw. der Stempel zur Herstellung der Parallelität zwischen den Kontaktflächen. Dadurch wird eine ungleichmäßige Druckbeaufschlagung der Komponenten vermieden und die Gefahr des Auftretens von Druckspitzen reduziert. Das Spiel kann von ca. 1µm bis 1mm betragen und kann insbesondere als paralleler Spalt zwischen Stempel und Führungskanal ausgeführt sein.

In der Regel weist der Stempel bzw. weisen die Stempel eine runde Querschnittsform auf. In einer weiteren Ausführungsform kann der Stempel bzw. können die Stempel einen elliptischen, quadratischen oder rechteckigen Querschnitt aufweisen. Hierbei sind bevorzugt die Führungsseiten, d.h. die Querschnittseckbereiche des bzw. der Stempel abgerundet um lokale Druckspitzen zu vermeiden. Der Stempel ist durch eine, dem Druckkissen zugewandte Stempeloberseite, einer der Pressseite und dem zu verpressenden Bauteil zugewandte Stempelunterseite, sowie durch einen axialen Stempelaußenmantel, die in dem Führungsrahmen geführt ist, begrenzt. Die Seitenflächen des Stempelaußenmantels werden als Führungsseiten bezeichnet und sind in dem Führungskanal geführt. Die Kantenübergänge der Führungsseiten sind vorteilhaft abgerundet, um eine verkantungsfreie Führung zu gewährleisten. Ein rechteckiger oder quadratische Ausbildung insbesondere der Stempelunterseite, aber auch des ganzen Stempelquerschnitts ermöglicht eine Anpassung des Stempelquerschnitts an eine typische Bauform von zu sinternden Bauteilen, insbesondere Halbleiter-Hochleistungsbauteile mit rechteckigen oder quadratischen Gehäuseformen, und ermöglicht eine Multistempeleinheit, die eine Mehrzahl von aneinander geführten, benachbarten und sich gegenseitig abdichtender Stempel, ohne dass zwischen den Stempeln eine Fehlstelle auftritt, sodass die Multistempeleinheit ohne Begrenzungswände des Führungsrahmen eine geschlossene Dichtungsoberfläche gegenüber dem Druckkissen ausbildet. Die Multistempeleinheit kann durch eine Metallfolie gegenüber dem Druckkissen abgedichtet sein, wobei es sich weiterhin anbietet, die Einzelstempel der Multistempeleinheit magnetisch mit der Metallfolie zu verbinden.

In Bezug auf die vorgenannte Ausführungsform kann weiterhin vorteilhaft der Führungsrahmen, insbesondere die Stempelführungsplatte, eine quadratische oder rechteckige Form besitzt, und die Führungskanäle eine quadratische oder rechteckige Querschnittsform aufweisen. Hierdurch wird eine Abdichtung des Druckkissens durch den Führungsrahmen und die in abgedichteten Führungskanälen geführten Stempeln erreicht, auch wenn keine zusätzliche Membran zur Abdichtung eingesetzt wird. Durch eine rechteckige oder quadratische Form kann die Fläche in Bezug auf die Presskraft verbessert genutzt werden, auch können mehrere Bauteile bei gleicher Kraft pro Fläche als bei runden Stempeln verarbeitet werde.

In einer vorteilhaften Ausführungsform kann ein oder können mehrere Führungskanäle eine Mehrzahl von dicht benachbarten Stempeln aufnehmen, die bevorzugt an sich selbst führbar sind. Diese Ausführungsform schlägt eine Multistempeleinheit als Stempelpacket vor, wobei der Führungsrahmen ein oder mehrere Führungskanäle aufweist, und mehrere Stempel in einem Führungskanal geführt sind. Die Stempel sind dabei im Führungskanal an sich selbst dichtend axial geführt und weisen Konturformen auf, die eine flächige Abdichtung durch die Mehrstempeloberfläche über dem Führungskanalquerschnitt ermöglicht. So können die Stempel konzentrische Formen zueinander aufweisen, oder rechteckig oder quadratisch benachbart aneinander geführt sein. Auch sonstige komplexe Querschnittsformen, die den Führungskanal ausfüllen, sind denkbar. Es ist dabei vorteilhaft, dass die Stempel gleiche oder unterschiedliche Längen zueinander aufweisen, um Bauteile mit konstantem oder variierendem Höhenprofil verpressen zu können.

In einer weiteren vorteilhaften Ausführungsform kann der Stempel bzw. können die Stempel auf einem dem Druckkissen zugewandten oberen Führungsseitenabschnitt einen Gleitführungseinsatz aus einem weicheren Material als das Stempelmaterial, bevorzugt Kunststoff, aufweisen. Bevorzugt kann auf der Stempeloberseite eine umlaufende Stempelnut zwischen der Oberkante des Gleitführungseinsatzes und der Stempeloberseite vorgesehen sein. Der Gleitführungseinsatz kann eine effiziente Abdichtung eines oberen, dem Druckkissen zugewandten Bereichs des Stempels gegenüber dem Führungsrahmen bzw. benachbarten Stempeln bereitstellen und kann bei Abnutzung kostengünstig ausgewechselt werden. Auch kann der Gleitführungseinsatz zur Befestigung der Stempel kraft- oder formschlüssig den Stempel in den Führungskanälen der Führungsplatte befestigen. Zur effizienten Abdichtung hat sich eine umlaufende Stempelnut, insbesondere eine scharfkantig abgegrenzte Stempelnut, am oberen Abschluss des Gleitführungseinsatzes gegenüber der Oberfläche der Stempeloberseite erwiesen, in der das Druckkissen einwirken kann. Besteht das Material des Gleitführungseinsatzes aus einem weicheren Material als das Stempelmaterial, typischerweise Kunststoff vs. Metall, so weist das Stempelmaterial in der Regel einen höheren thermischen Ausdehnungskoeffizienten auf, und dichtet somit bei höheren Temperaturen besser ab. Daneben kann das weichere Material ein paralleles Ausrichten des Stempels gegenüber der Oberfläche des Bauteils bzw. der Baugruppe bereitstellen. Durch die umlaufende Stempelnut fließt das Druckkissenmaterial z.B. Silikon in die Stempelnut und verpresst den Gleitführungseinsatz an die äußere Wand des Führungskanals. Weist weiterhin die zur Stempelführungsseite weisende Oberfläche des Gleitführungseinsatzes eine reibminderte Oberflächenkontur auf, z.B. eine profilierten Wellenoberfläche, so wird die axiale Stempelbewegung mit verringertem Widerstand gedichtet und der Gleitführungseinsatz verbleibt an der Führungsseite des Stempels an seinem Platz. Der Gleitführungseinsatz kann vorzugsweise auf Basis einer 3D-Drucktechnologie hergestellt und insbesondere unmittelbar neben der Stempelnut auf einen oberen umlaufenden Stempel-Führungsseitenabschnitt aufgedruckt bzw. angespritzt werden. Durch einen erhöhten thermischen Ausdehnungskoeffizienten des Materials des Gleitführungseinsatzes wird eine zuverlässige Abdichtung in den Führungskanäle der Führungsplatte ermöglicht. Durch den Einsatz des Gleitführungseinsatzes kann eine so hohe Dichtwirkung gegenüber dem Druckkissen erreicht werden, so dass auf eine Membran als Abdichtelement verzichtet werden kann. Als Stempel kann vorteilhaft eine vorgenannte Multistempeleinheit eingesetzt werden, wobei am oberen Abschluss des Gleitführungseinsatzes eine Metallfolie eine Abdichtung gegenüber dem darüber liegenden Druckkissen ausbilden kann. Weiterhin können die Einzelstempel der Multistempeleinheit magnetisch auf der Metallfolie kraftschlüssig befestigbar sein.

In einer weiteren vorteilhaften Ausführungsform kann der bzw. können die Stempel auf der Stempelunterseite einen kleineren oder größeren Querschnitt als auf der Stempeloberseite aufweisen. Verschiedene Oberflächenquerschnitte der Stempeloberseite gegenüber der Stempelunterseite ermöglichen eine Druckvergrößerung bzw. Druckverkleinerung und ermöglichen eine effiziente Abdichtung des Druckkissens. Adaptiv können Bereiche der zu sinternden Bauteile mit erhöhtem oder reduziertem Druck verpresst werden, auch kann die Querschnittskontur der Stempelunterseite spezifischen Anforderungen der Bauteilgeometrie angepasst werden.

In einer weiteren vorteilhaften Ausführungsform kann der Kolben gegenüber dem Zylinder abgedichtet versetzbar geführt sein. Der Kolben dient zur Druckerhöhung im Druckkissen, dass in Folge die Stempel aus dem Oberwerkzeug in Richtung Unterwerkzeug presst. Durch Zufahren von Ober- und Unterwerkzeug wird auf den im Zylinder beweglichen Kolben, der sich auf dem Unterwerkzeug, insbesondere der Baugruppe oder einem Werkstückträger abstützt eine Presskraft ausgeübt, die dieser auf das Druckkissen weitergibt. Zur Abdichtung kann der oder die Stempel in der Führungsplatte gegenüber dem Druckkissen beispielsweise über eine große Membrane, insbesondere über eine Metallmembran, abgedichtet sein, oder jeder Stempel kann in der Führungsplatte einzeln oder als Gruppe gegenüber dem Druckkissen, beispielsweise über Membranabschnitte oder durch zusätzliche Dichtelemente an den Stempeln, abgedichtet sein. Dabei kann der Stempel durch eine Unterseite des Druckkissens, insbesondere eines Silikonkissens ausgebildet sein, die unmittelbar oder unter Zwischenlage einer Prozessabdeckung wie einer Sinterfolie oder dergleichen die Baugruppe verpresst. Die Sinterfolie kann ein paralleles Ausrichten des Stempels des Oberwerkzeugs gegenüber der Oberfläche des Bauteils bzw. der Baugruppe auf dem Unterwerkzeug unterstützen. Des Weiteren verhindert eine Sinterfolie ein Anhaften des Silikonmaterials auf der Bauteiloberfläche. Weiterhin ist bevorzugt der Kolben als Ringkolben ausgeformt sein, und bevorzugt einen Kolbenmantel aus einem härteren Werkstoff, insbesondere Stahl, und einen formschlüssig in den Kolbenmantel aufgenommenen Kolbendichteinsatz aus einem weicheren Werkstoff, insbesondere Kunststoff umfassen. Der Kolbendichteinsatz aus einem weicheren Werkstoff kann durch Erwärmung und Druckbeaufschlagung das Druckkissen in der Öffnung der Druckkammer derart abdichten, dass dieses nicht am Spalt zwischen Kolben und Zylinder der Druckeinheit herausdrängen kann. Die Materialwahl des Kolbendichteinsatzes kann angepasst an Druck, Temperatur und Material des Druckkissens eine Abdichtung des Druckkissens im Zylinder bei Druckbeaufschlagung gewährt werden kann. Des Weiteren unterstützt der Kolbendichteinsatz aufgrund seiner nachgiebigen, weichen Eigenschaft ein paralleles Ausrichten der Stempeloberfläche auf der Bauteiloberfläche und dient zur parallelen Ausrichtung der Stempeloberfläche des Oberwerkzeugs zur Bauteiloberfläche des Unterwerkzeugs. Die Zylinderquerschnittsform kann vorzugsweise kreisförmig sein, um eine gleichmäßige Druckverteilung bereitzustellen. Durch Einsatzes des Kolbendichteinsatzes sind aber auch elliptische, quadratische, rechteckige, mehreckige oder andere Zylinderquerschnittsformen denkbar, die angepasst an die zu bearbeitenden Baugruppen insbesondere eine kompakte, platzsparende Anordnung von Baugruppen auf Werkstückträgern und einen hohen Produktionsdurchsatz auch bei hohen Temperaturen und Drücken ermöglichen. Dabei sind Querschnittsformen, insbesondere quadratische oder rechteckige Querschnittsformen mit abgerundeten Kantenbereichen zu bevorzugen, um die Dichtheit der Kolben-Zylinderabdichtung gegenüber dem Druckkissen dauerhaft zu gewährleisten. Der Ringkolben kann ein Spiel gegenüber der Zylinderwandung aufweisen, um ein Gleiten des Ringkolbens im Zylinder zu ermöglichen, wobei durch die vorgenannte Abdichtung ein Eindringen des Druckkissenmaterials - auch ohne Zwischenmembran - in den Spalt zwischen Ringkolben und Zylinder verhindert werden kann. Im Inneren des Ringkolbens kann das Druckkissen spaltfrei an der Innenwandung des Kolbendichteinsatzes ermöglicht werden. Insoweit wird in dieser Ausführungsform der Stempel spaltfrei in dem Führungskanal, der durch die Innenwandung des Ringkolbens dargestellt ist, geführt.

In einer weiteren vorteilhaften Ausführungsform kann der Kolbenmantel einen Dichtungssitz an seiner, dem Oberwerkzeug zugewandten, Kolbenoberseite aufweisen, in dem ein Flanschbereich des Kolbendichteinsatzes derart eingreift, dass eine umlaufende Dichtungsnut ausgebildet sein kann. Bevorzugt kann ein Druckkissen auf der Oberseite einen umlaufenden Dichtrand aufweisen, der bei einer Druckbeaufschlagung auf den Kolben mit einer sich ausbildenden Dichtnaht in die Dichtungsnut des Kolbens gedrängt werden kann. Durch den Eingriff eines Flanschbereichs des Kolbendichteinsatzes in einen Dichtungssitz des Kolbenmantels, kann zum einen eine formschlüssige Aufnahme des Kolbendichteinsatzes ermöglicht werden, zum anderen eine Dichtungsnut ausgebildet werden, die Raum für ein Verdrängen des Druckkissens bereitstellt, so dass durch die Dichtungsnut eine Selbstabdichtwirkung des Druckkissens gegenüber dem Spalt zwischen Kolben und Zylinder bereitgestellt wird. Der Kolbendichteinsatz kann bei Verschleiß oder Umrüstung leicht ausgetauscht werden.

In einer weiteren vorteilhaften Ausführungsform kann der Kolben und das Druckkissen einem Stempel zugeordnet sein, insbesondere kann der Stempel als Softstempel ausgebildet sein, und kann bevorzugt durch das Druckkissen bereitgestellt sein, oder der Kolben und das Druckkissen können einer Mehrzahl von Stempeln zugeordnet sein. In dieser Ausführungsform wird vorgeschlagen, dass im Oberwerkzeug eine oder mehrere Druckeinheiten angeordnet sein können, wobei jede Druckeinheit ein Einzelstempel aufweist. Besteht die Druckeinheit im Wesentlichen aus dem Zylinder mit aufgenommenen Druckkissen, Ringkolben und einem Führungsrahmen, so kann jede Druckeinheit einen Einzelstempel ausbilden. Dabei kann die Unterseite des Druckkissens beispielsweise als Softstempel, z.B. als Silikonstempel dienen, aber auch als Hartstempel mit einer harten Stempelfläche ausgebildet sein. Alternativ kann eine einzelne, große Druckeinheit im Oberwerkzeug angeordnet sein, wobei im Führungsrahmen eine Mehrzahl kleiner Stempel angeordnet sein können.

In einem nebengeordneten Aspekt wird ein Presswerkzeug, ausgebildet als ein Oberwerkzeug oder ein Unterwerkzeug einer vorgenannten Diffusionslöt- und/oder Sintervorrichtung vorgeschlagen. Diese umfasst eine starre Grundplatte und, entweder zumindest eine mit der Grundplatte verbundene Membrane, welche durch eine biegsame, vorzugsweise topfförmig geformte, bevorzugt aus Silikon oder einer Stahllegierung hergestellte Membran gebildet ist, oder eine Vielzahl von Membranabschnitten, in Richtung Pressfläche , oder einen Führungsrahmen mit darin versetzbar führbaren, abgedichten Stempeln, und mit einer Druckkammer, die vorzugsweise ein mit einem Fluid befülltes Druckkissen beinhaltet, welches in einem abgeschlossenen Aufnahmeraum angeordnet ist, welches durch die Grundplatte und die Membrane oder den Führungsrahmen mit abdichtenden Stempeln begrenzt ist, wobei der Führungsrahmen das Druckkissen (in Richtung Pressfläche abschließt und die Stempel führt. Das bzw. die Membrane und/oder die Stempeldichtungen dichten die Druckkammer bzw. das Druckkissen, vorzugsweise aus Silikon, gegenüber der Pressfläche ab und ermöglichen die Anordnung der Stempel auf der Membranfläche bzw. dem Führungsrahmen, wobei beispielsweise bei metallischen Membranen eine magnetische Befestigung erleichtert wird, allerdings auch andere Verbindungstechnicken wie Schraubverbindung, Schweißverbindung, Nietverbindung oder ähnliches denkbar sind.

In einer vorteilhaften Weiterbildung kann ein Teilbereich der Druckkammer des vorstehend beschriebenen Presswerkzeugs, insbesondere zumindest ein Teilbereich eines in der Druckkammer aufgenommen Druckkissens steuerbar fluidbefüllbar ausgebildet sein, insbesondere gasbefüllbar sein. Bevorzugt kann die Fluidbefüllung mittels zumindest eines Füllventils steuerbar sein. Durch die Fluidbefüllung, insbesondere Gasbefüllung eines Teilbereichs der Druckkammer, insbesondere eines Teilbereichs, kann zusätzlich oder alternativ zu der durch die Presse mechanisch aufgebrachte Presskraft eine Presskraft durch eine Fluidfüllung in die Druckkammer erzeugt werden. So kann beispielsweise durch Einleitung von Atmosphärengas der Prozesskammer, ggf. auch Spülgas wie Stickstoff etc., in einen Teilbereich der Druckkammer bei Druckverringerung oder Vakuumierung der Prozesskammer eine Ausdehnung der Druckkammer durch die Membrane hindurch bzw. durch Verschiebung der abgedichteten Pressstempel erfolgen. Hierdurch wird ein vergleichsweise geringer, allerdings in vielen Fällen ausreichender Druck beispielsweise für ein Bondingverfahren, Niederdrucksintern mit Silber oder Kupfer, Diffusionslöten bei beispielsweise bis zu 0,4 MPa, Thermokompressionsbonden bei bspw. bis zu 0,1 MPa etc. auf die Bauelemente erzeugt, ohne dass eine Hydraulikpresse die Pressstempel mechanisch betreibt. Somit ist alleine durch Einstellung einer definierten Prozessatmosphäre in der Prozesskammer und/oder der Druckkammer eine exakt dosierbare Presskraftaufbringung auf das Bauelement möglich, die mit einer mechanischen Presse durch Verfahren von Unter- und Oberwerkzeug relativ zueinander nicht aufbringbar wäre.

Durch die vorgenannte Ausführungsform kann kostengünstig und einfach ein Presswerkzeug mit geringem Aufwand für eine zusätzliche oder alternative Druckbeaufschlagung zum Pressenantrieb bereitgestellt werden. Denn über den Gasdruck und der Prozessatmosphäre bzw. Vakuum in der Prozesskammer, welches für den Prozess grundsätzlich benötigt wird, kann ein gewünschter und gesteuerter Sinterdruck oder Diffusionslötdruck oder Bonddruck auf Bauelemente ausgeübt werden, um Höhenunterschiede von Bauteile auf dem Bauelement ausgleichen zu können.

Hierzu ist kein zusätzliches Kraftmesssystem oder Druckmesssystem notwendig, den ein Vakuumdrucksensor und eine einfach Softwareflächenumrechnung genügt, um einen gewünschten und eingestellten Sinterdruck oder Diffusionslötdruck oder Bonddruck zu erreichen.

Da die Vakuumkammer im Vakuum über das Presswerkzeug Druck auf das Bauelement oder die Bauelemente ausübt, kann dauerhaft, während des Prozesses, überwacht werden, ob Sauerstoff von außen in die Vakuumkammer eindringt, da ein unerwarteter Kammerdruckanstieg umgehend erkannt werden kann. Hierdurch ist sichergestellt dass das heiße Bauelement nicht oxidiert, insbesondere Kupferoberflächen nicht oxidieren. Eine Drucküberwachung der Bauelemente kann über eine Kraftmessdose, die beispielsweise im Pressenantrieb umfasst ist, vorgenommen werden. So kann beispielsweise ein Klemmen eines Stempels erkannt werden.

In einem weiteren nebengeordneten Aspekt wird eine Diffusionslötanlage und/oder Sinteranlage vorgeschlagen, die eine vorgenannten Diffusionslötvorrichtung und/oder Sintervorrichtung und/oder ein vorgenanntes Presswerkzeug umfasst. Es wird vorgeschlagen, dass die Diffusionslötvorrichtung und/oder Sintervorrichtung und/oder das Presswerkzeug in einem atmosphärendichten Modul einer Mehrmodulanlage, insbesondere in einem Vakuummodul, angeordnet ist, wobei zumindest ein weiteres Modul als Vorheiz- und/oder Abkühlmodul vorgesehen ist. Des Weiteren ist eine Transporteinrichtung vorgesehen ist, die eingerichtet ist, zumindest einen Werkstückträger, insbesondere das Unterwerkzeug, mit zumindest einer Baugruppe automatisch durch die Mehrmodulanlage zu bewegen. Weiterhin sind benachbarte Module der Mehrmodulanlage atmosphärendicht gegeneinander verschließbar sind.

Mit anderen Worten wird eine Mehrmodulanlage vorgeschlagen, die zumindest ein atmosphärendichtes Modul umfasst, insbesondere ein Vakuummodul, das die vorgenannte Sinter- oder Diffusionslötvorrichtung und/oder das vorgenannte Presswerkzeug umfasst. Innerhalb dieses Sinter-/Diffusionslöt-Moduls kann unter spezifisch einstellbaren Atmosphärenbedingungen, insbesondere unter Vakuum zur Elimination von Oxidationsprozessen der Sinter- und/oder Diffusionslötprozess durchgeführt werden. Zumindest ein weiteres Modul kann als Vorheizmodul und/oder als Abkühlmodul zur Reduktion der Prozesszeiten sowie zur speziellen Vor- und/oder Nachbehandlung, z.B. zur Reinigung insbesondere mit einem Prozessgas wie Plasma, Ameisensäure, Stickstoff etc. und Temperierung eingerichtet sein. Ein Werkstückträger, der zumindest ein, insbesondere mehrere Baugruppen bzw. Bauelemente trägt, kann durch eine Transporteinrichtung, z.B. ein Fließbandsystem durch die Module geführt werden. Gleichwohl kann das gesamte Unterwerkzeug mittels der Transporteinrichtung durch die Mehrmodulanlage durchgeführt werden. Der Übergang der Module kann atmosphärendicht verschließbar, z.B. mittels einer Gasschleuse verschließbar sein, so dass Atmosphäre, Druck und Temperatur in jedem Modul getrennt eingestellt werden kann. Die Mehrmodulanlage kann für einen Batchbetrieb in der Fließfertigung ausgelegt und als Durchlaufanlage ausgelegt sein, wobei entweder die Transporteinrichtung die Baugruppen durch die Mehrmodulanlage durchführt, oder hinein und wieder zurückführt.

### ZEICHNUNGEN

Weitere Vorteile ergeben sich aus der vorliegenden Zeichnungsbeschreibung. In den Zeichnungen sind Ausführungsbeispiele der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen. Ausführungsbeispiele, die für eine Sintervorrichtung dargestellt sind, können gleichwohl für Diffusionslötvorrichtungen umgesetzt werden.

Es zeigen:
- **Figs. 1 und 2**: schematische Schnittansichten einer Sintervorrichtung gemäß einem Ausführungsbeispiel in verschiedenen Arbeitsstellungen,
- **Fig. 3**: eine perspektivische Ansicht der Sintervorrichtung von Fig. 1 und 2 in einer Ruhestellung,
- **Fig. 4**: eine perspektivische Ansicht in teilweiser Schnittdarstellung der Sintervorrichtung von Fig. 1 bis 3,
- **Fig. 5**: eine Seitenansicht der Sintervorrichtung von Fig. 1 bis 4,
- **Fig. 6**: eine perspektivische Ansicht eines Führungsrahmens der Sintervorrichtung von Fig. 1 bis 5,
- **Fig. 7**: eine perspektivische Explosionsdarstellung des Führungsrahmens von Fig. 6,
- **Fig. 8**: eine perspektivische Ansicht eines Bauteils des Führungsrahmens von Fig. 7,
- **Figs. 9 und 10**: Teilansichten des Führungsrahmens von Fig. 6 und 7 in unterschiedlichen Perspektiven,
- **Fig. 11**: eine perspektivische Teilansicht in Schnittdarstellung des Führungsrahmens von Fig. 6 und 7 gemäß einer Ausgestaltung,
- **Fig. 12**: eine perspektivische Ansicht eines Führungsrahmens gemäß einer weiteren Ausgestaltung, und
- **Fig. 13**: eine perspektivische Teilansicht in Schnittdarstellung des Führungsrahmens von Fig. 12;
- **Fig. 14**: eine Explosionsdarstellung eines Pressenwerkzeugs einer Sintervorrichtung gemäß einer Ausführungsform der Erfindung;
- **Figs. 15a, 15b**: eine Schnittdarstellung durch Varianten der Ausführungsform nach Fig. 14;
- **Fig. 16**: eine schematische Seitenansicht einer Sintervorrichtung eines weiteren Ausführungsbeispiels;
- **Figs. 17a-17c**: ein weiteres Presswerkzeug in mehreren Verfahrensstufen einer Sintervorrichtung gemäß einem Ausführungsbeispiel;
- **Figs. 18a, 18b**: Schnittdarstellungen von abgedichteten gedichteten Pressstempeln nach Ausführungsformen der Erfindung;
- **Fig. 19**: eine Ausführungsform eines Presswerkzeugs mit einem in Fig. 18a dargestellten abgedichteten gedichteten Pressstempel;
- **Fig. 20**: perspektivisch eine Multistempeleinheit einer Ausführungsform mit gegenseitig benachbarten und zueinander abgedichtet versetzbaren Stempeln;
- **Figs. 21a, 21b**: Draufsicht und Schnittansicht eines quadratischen Ringkolbens mit Silikon-Druckkissen eines Ausführungsbeispiels der Erfindung.

In der folgenden Beschreibung beispielhafter Ausführungsformen und Ausgestaltungen sind gleiche oder gleichartige Elemente mit denselben Bezugszeichen bezeichnet.

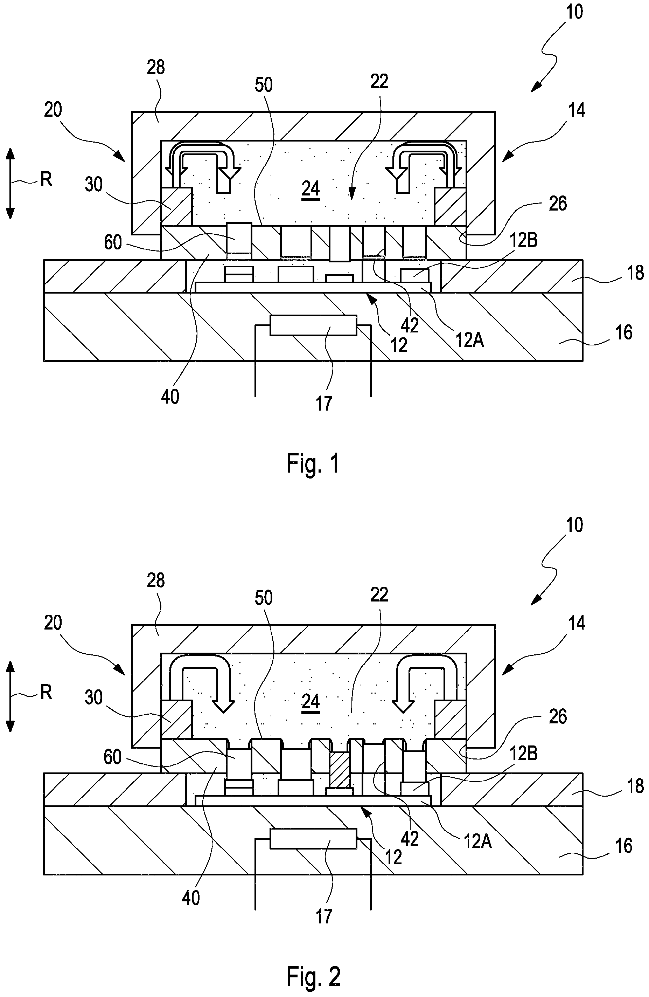

Fig. 1 und 2 zeigen eine beispielhafte Sintervorrichtung 10 zum Verbinden von Komponenten einer Mehrzahl von elektronischen Baugruppen 12 mittels Drucksintern. Gleichwohl kann auch nur eine einzelne Baugruppe 12 gesintert werden. Aus Gründen der Übersichtlichkeit ist in Fig. 1 und 2 jeweils nur eine einzige Baugruppe 12 dargestellt, welche ein Substrat 12A und mehrere unterschiedlich große elektronische Bauelemente 12B umfasst.

Die Sintervorrichtung 10 umfasst ein Oberwerkzeug 14 und ein Unterwerkzeug 16, welche relativ zueinander entlang einer durch einen Doppelpfeil R dargestellten Pressrichtung R verstellbar sind. Aus Gründen der Übersichtlichkeit sind weitergehende Komponenten der Sintervorrichtung 10 wie Verstellvorrichtungen oder Haltevorrichtungen für die Werkzeuge 14, 16 nicht dargestellt.

Das Oberwerkzeug 14 und das Unterwerkzeug 16 können beheizbar sein, wobei hier vereinfachend lediglich eine am Unterwerkzeug 16 vorgesehene Heizvorrichtung 16 dargestellt ist.

Die zu sinternden Baugruppen 12 können gemäß einer Ausgestaltung in einem Werkstückträger 18 aufgenommen sein, welcher bevorzugt für einen vereinfachten Werkstückwechsel mittels entsprechender Transportvorrichtungen automatisiert in die Sintervorrichtung 10 eingeführt, auf dem Unterwerkzeug 16 platziert und nach erfolgter Sinterung wieder aus der Sintervorrichtung 10 entnommen werden kann.

Das Oberwerkzeug 14 umfasst eine Druckeinheit 20, welche einen Aufnahmeraum oder eine Aufnahme 22 für ein Druckkissen 24 definiert, welches die Aufnahme 22 vollständig ausfüllt. Das Druckkissen 24 definiert ein Volumen, welches von einer fluiddichten flexiblen Hülle oder Kissenmembran umgeben ist und mit einem Fluid, beispielsweise einem Elastomer wie Silikon oder Fett, oder auch einem Gas befüllt ist. Die Hülle kann beispielsweise aus einem beschichteten Glasfaser- oder Aramidfaser-Gewebe (Kevlar) hergestellt sein. Die Beschichtung kann beispielsweise unter Verwendung von Polytetrafluorethylen (PTFE) hergestellt sein.

Die Druckeinheit 20 umfasst einen Zylinder 28, in welchem ein Kolben 30 entlang der Pressrichtung R versetzbar geführt ist. Die Aufnahme 22 weist an einer dem Unterwerkzeug 16 zugewandten Unterseite eine Öffnung 26 auf, welche im Ausführungsbeispiel sich innerhalb des Kolbens 30 erstreckt, so dass der Kolben 30 eine Art zylindrischen Ringkolben bildet. Die Aufnahme 22 wird im Bereich der Öffnung 26 von einem Führungsrahmen 40 begrenzt, welcher mehrere Führungskanäle 42 aufweist, in denen jeweils ein oder mehrere Stempel 60 axial entlang der Wirkrichtung der Presskraft, d.h. in der Pressrichtung R, versetzbar geführt sind. Die Stempel 60 sind bevorzugt aus einem gut wärmeleitenden, widerstandsfähigen Material hergestellt, beispielsweise aus Stahl oder auch aus einem anderen Metall oder einer Metalllegierung. Der Führungsrahmen 40 ist an dem Kolben 30 mit Hilfe geeigneter Verbindungselemente, beispielsweise Rast- oder Klemmelemente, befestigt oder mit dem Kolben 30 verschraubt, so dass ein Austausch des Führungsrahmens 40 möglich ist.

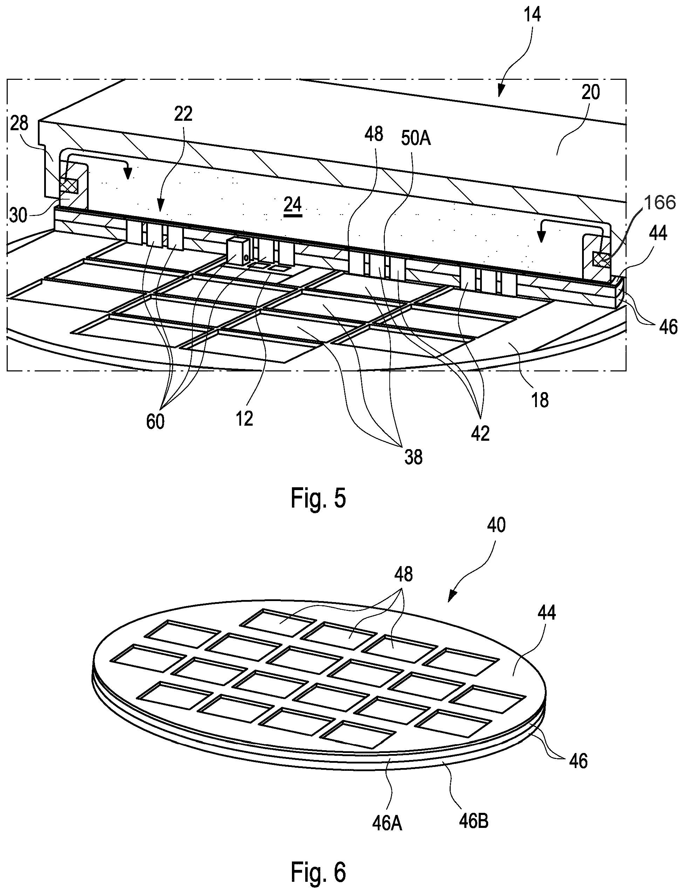

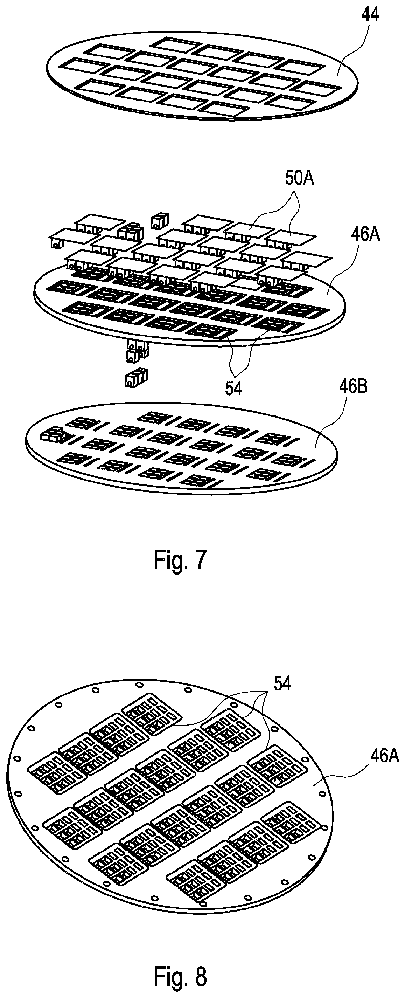

Zwischen der Aufnahme 22 bzw. dem Druckkissen 24 ist eine flexible Membran 50 angeordnet, welche die Führungskanäle 42 überdeckt. In dem in Fig. 1 und 2 dargestellten Ausführungsbeispiel ist die Membran als durchgehende Membran 50 dargestellt, wobei gemäß einer nachfolgend noch näher beschriebenen Abwandlung die Membran auch in mehrere separate Membranabschnitte 50A (Fig. 5 und 7) unterteilt sein kann. Die Membran 50 oder die Membranabschnitte 50A können beispielsweise ebenfalls aus einem beschichteten Glasfaser- oder Aramidfaser-Gewebe (Kevlar) hergestellt und ggf. unter Verwendung von Polytetrafluorethylen (PTFE) oder anderem Material beschichtet sein.

Nachfolgend wird die Funktionsweise der Sintervorrichtung 10 erläutert. Wie in Fig. 1 dargestellt ist, werden nach erfolgter Platzierung der Baugruppen 12 bzw. des Werkstückträgers 18 auf dem Unterwerkzeug 16 zunächst das Oberwerkzeug 14 und das Unterwerkzeug 16 einander angenähert, was entweder durch ein Versetzen des Oberwerkzeugs 14 oder des Unterwerkzeugs 16 erfolgen kann. Bei der in Fig. 1 dargestellten Situation setzt gerade das Oberwerkzeug 14 mit dem Führungsrahmen 40 auf dem Unterwerkzeug 16 bzw. genauer auf dem auf dem Unterwerkzeug 16 gelagerten Werkstückträger 18 auf.

Sobald der Führungsrahmen 40 auf dem Werkstückträger 18 aufgesetzt hat, wird bei einer weiteren Annäherung von Ober- und Unterwerkzeug 14, 16 das Volumen der Aufnahme 22 verkleinert, da der Kolben 30 in den Zylinder 28 hineinversetzt wird. Hierbei wird in dem Druckkissen 24 ein Druck aufgebaut, welcher die Stempel 60 in Richtung auf die Baugruppen 12 hin aus den Führungskanälen 42 hinaus versetzt oder verdrängt. Hierbei passt sich die Hülle des Druckkissens 24 und auch die Membran 50 weitgehend an die Konturen des Führungsrahmens 40 bzw. der Oberseite der Stempel 60 an.

Sobald die Stempel 60 in Kontakt mit den Bauelementen 12B treten, baut sich ein gewisser Druck auf, welcher zunächst noch sehr gering ist, bis alle Bauelemente 12B von den zugeordneten Stempeln 60 kontaktiert werden. Das Druckkissen 24 ermöglicht einen hydraulischen Ausgleich, so dass ein größerer Druckanstieg innerhalb des Druckkissens 24 erst dann erfolgt, wenn alle Stempel 60 an den zugeordneten Bauelementen 12B anliegen. Dadurch wird ein simultaner und gleichmäßiger Aufbau der Presskraft bzw. des Pressdrucks erzielt, so dass das Drucksintern der Baugruppen12 in einer sehr gleichmäßigen Weise erfolgt. Zur Ermittlung des Pressdrucks kann die Sintervorrichtung 10 entsprechende Sensoren aufweisen. Die Wärmeübertragung von einer im Oberwerkzeug 14 vorgesehenen Heizvorrichtung (nicht dargestellt) auf die Baugruppen 12 kann auf mehreren Wegen über den Zylinder 28, den Kolben 30, das Druckkissen 24, die Stempel 60, den Führungsrahmen 40 und die Membran 50 erfolgen. Eine nicht dargestellte Steuervorrichtung kann die Prozessparameter wie Pressdruck, Presszeit und/oder Presstemperatur gemäß einer vorgegebenen Prozessvorschrift steuern bzw. regeln.

Nach Beendigung des Sintervorgangs, werden das Oberwerkzeug 14 und das Unterwerkzeug 16 voneinander entfernt, so dass der Werkstückträger 18 mit den Baugruppen 12 freigegeben wird und aus der Sintervorrichtung 10 entnommen werden kann.

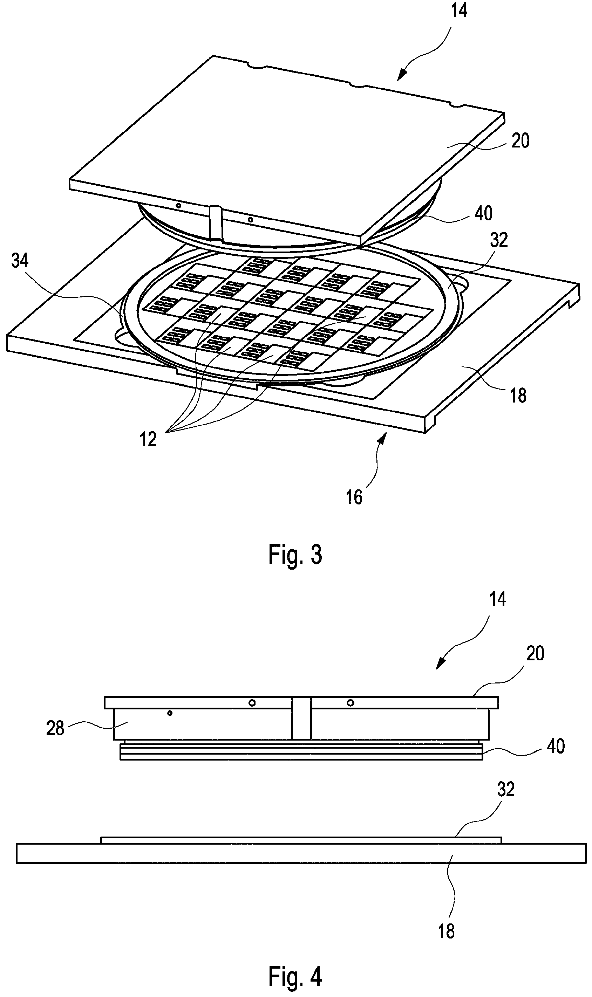

Mit Bezug nun auf Fig. 3 bis 13 werden verschiedene Komponenten der Sintervorrichtung 10 gemäß der beispielhaften Ausführungsform und Abwandlungen davon näher beschrieben.

In Fig. 3 ist zum einen das Oberwerkzeug 14 mit der Druckeinheit 20 und dem daran befestigten Führungsrahmen 40 dargestellt. Auf dem Unterwerkzeug 16 ist der Werkstückträger 18 aufgelegt, welcher mehrere zu sinternde elektronische Baugruppen 12 in entsprechenden Fächern trägt. Um die Baugruppen 12 gegen Verschmutzung oder Kontamination zu schützen, kann auf dem Werkstückträger 18 eine Folie (in Fig. 3 nicht sichtbar) angeordnet sein, welche durch einen aufgelegten Folienhaltering 32 gegen unbeabsichtigtes Verrutschen gesichert werden kann. Um seinerseits den Folienhaltering 32 gegen ein Verrutschen zu sichern, kann der Werkstückträger 18 eine entsprechende Vertiefung oder Rille 34 aufweisen. Die Folie kann ein paralleles Ausrichten zwischen Oberwerkzeug 14 und Unterwerkzeug 16 und einen Höhenausgleich verbessern.

Der Durchmesser des Folienhalterings 32 kann so gewählt sein, dass der Führungsrahmen 40 innerhalb des Folienhalterings 32 auf dem Werkstückträger 18 aufliegt und somit nicht in Kontakt mit dem Folienhaltering 32 gelangt. Alternativ kann der Durchmesser des Folienhalterings auch kleiner gewählt werden, so dass der Führungsrahmen 40 auf dem Folienhaltering 32 aufsetzt, wodurch dann der Pressdruck in der Druckeinheit 20 erzeugt wird.

In Fig. 4 ist die Anordnung von Fig. 3 in einer Seitenansicht dargestellt, wobei nur der Werkstückträger 18, nicht jedoch das Unterwerkzeug 16 gezeigt ist. In Fig. 4 ist bereits erkennbar, dass der Führungsrahmen 40 mehrteilig aus mehreren Platten aufgebaut ist, was nachfolgend noch näher erläutert wird.

Mit Bezug auf Fig. 5 wird der Aufbau des Oberwerkzeugs 14 einschließlich der Druckeinheit 20 und des Führungsrahmens 40 näher erläutert. Der Aufbau der Druckeinheit 20 entspricht der Darstellung von Fig. 1 und 2. In Fig. 5 und auch in Fig. 6 ist der mehrteilige Aufbau des Führungsrahmens 40 illustriert. Der Führungsrahmen 40 umfasst eine zweiteilige Stempelführungsplatte 46 mit einer oberen Stempelführungsplatte 46A und einer unteren Stempelführungsplatte 46B. Die Führungskanäle 42 erstrecken sich durch beide Stempelführungsplatten 46A, 46B hindurch. Die Stempel 60 sind mit einem gewissen seitlichen Spiel in den Führungskanälen 42 geführt, so dass sich die Stempel 60 innerhalb der Führungskanäle 42 auch um ein gewisses Maß verkippen können. Beispielsweise können die Führungskanäle 42 und die Stempel 60 einen quadratischen Querschnitt aufweisen, wobei die Kantenlänge bei den Führungskanälen 42 8,00 mm und bei den Stempeln 60 7,96 mmm betragen kann. Diese Masse sind rein beispielhaft und keinesfalls einschränkend.

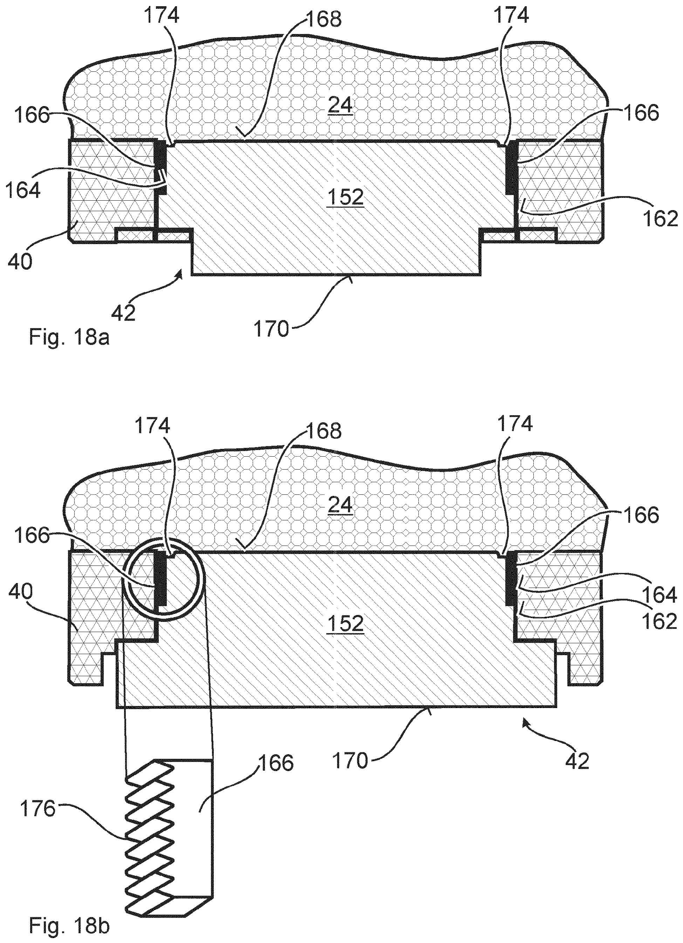

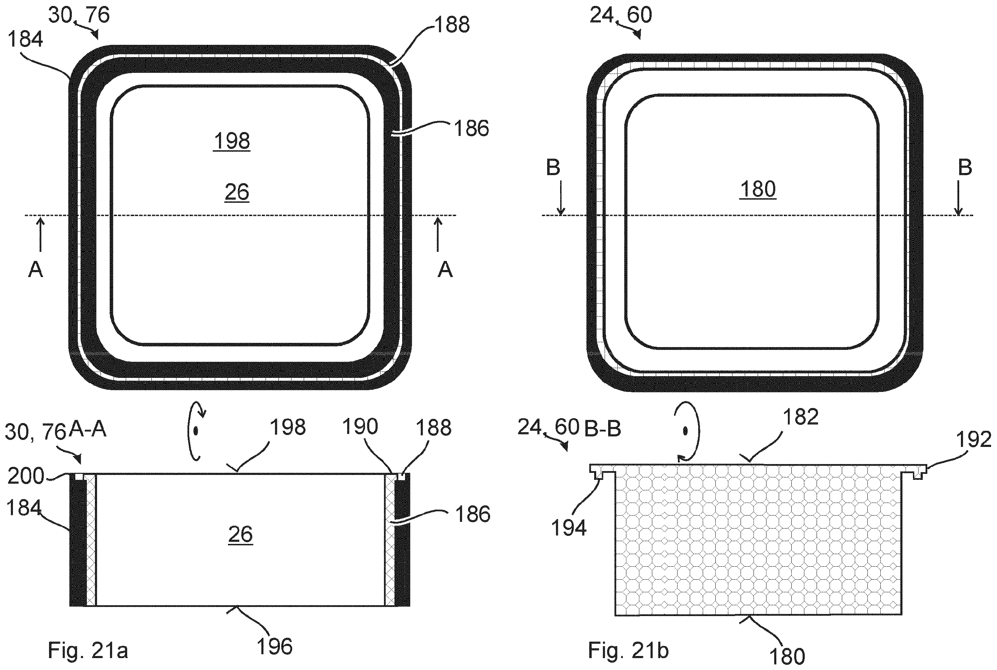

Der Kolben 30 kann gegenüber dem Zylinder 28 durch einen Gleitführungseinsatz 166 abgedichtet sein, wie er in den Figs. 18a, 18b ausführlich erläutert ist. Alternativ kann auch ein Abdichtprinzip mit einem Kolbendichteinsatz, wie sie in Bezug auf die Figs. 21a, 21b dargestellt ist, eingesetzt werden.

Durch dieses mäßige Spiel wird gewährleistet, dass sich die in Wirkverbindung tretenden Oberflächen der Stempel 60 und der Baugruppen 12 ggf. parallel zueinander ausrichten können, um eine Gradientenbildung bei der Ausübung der Presskraft zu vermeiden und die Homogenität der Pressung weiter zu verbessern.

Wie insbesondere in Fig. 6 gut zu erkennen ist, ist oberhalb der Stempelführungsplatte 46 eine Membranhalteplatte 44 angeordnet, welche mehrere Durchbrechungen 48 aufweist, die jeweiligen, im Werkstückträger 18 ausgebildeten Fächern 36 zur Aufnahme der Baugruppen 12 zugeordnet sind. Jede Durchbrechung 48 kann mehrere Führungskanäle 42 und die darin angeordneten jeweiligen Stempel 60 überspannen.

Jeder Durchbrechung 48 ist ein jeweiliger Membranabschnitt 50A zugeordnet, welcher bevorzugt etwas größer ist als die zugeordnete Durchbrechung 48, so dass die Membranabschnitte 50A zwischen der Stempelführungsplatte 46 und der Membranhalteplatte 44 eingeklemmt und in Position gehalten werden können.

Die Membranhalteplatte 44, die obere Stempelführungsplatte 46A und die untere Stempelführungsplatte 46B können miteinander verschraubt sein.

Wie in Fig. 7 zu erkennen ist, können an der Oberseite der oberen Stempelführungsplatte 46A entsprechende Vertiefungen 54 ausgebildet sein, welche bezüglich ihrer Größe auf die zugeordneten Membranabschnitte 50A abgestimmt sind. Gemäß einer Ausgestaltung kann die Tiefe der Vertiefungen 54 derart an die Dicke der Membranabschnitte 50A angepasst werden, dass die Membranabschnitte 50A etwas nach oben aus den Vertiefungen 54 herausstehen und somit mittels der Membranhalteplatte 54 geklemmt werden können.

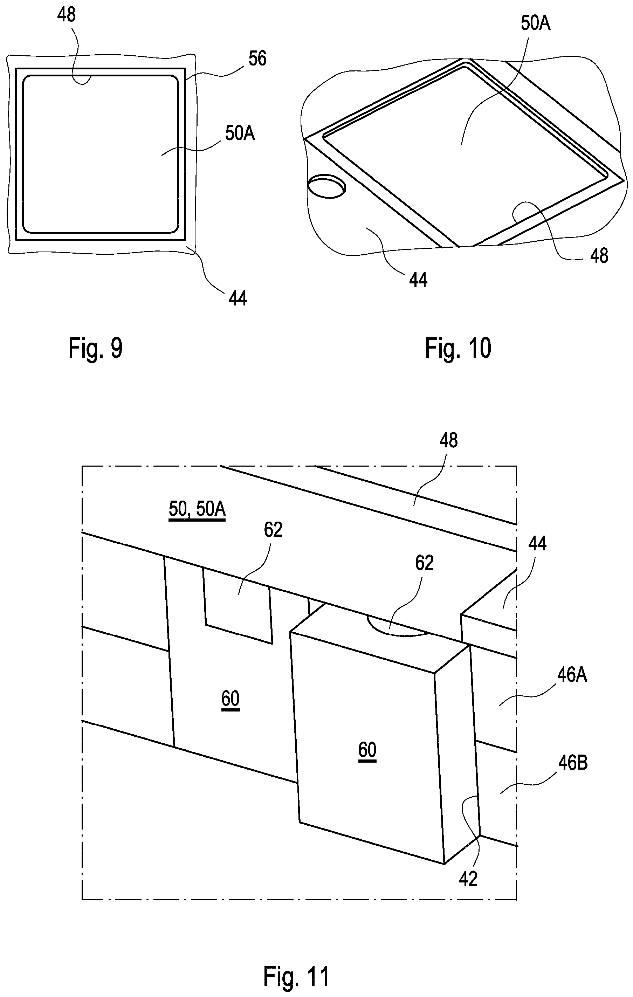

Gemäß einer in Fig. 9 und 10 dargestellten Ausgestaltung kann die Membranhalteplatte 44 für jede Durchbrechung 48 einen jeweiligen umlaufenden Dichtrand 56 aufweisen, welcher beabstandet vom Rand der Durchbrechung 48 verläuft und als eine Art Wulst ausgebildet ist, welcher den zugeordneten Membranabschnitt 50A umfangsseitig einspannt. Der Dichtrand 56 kann entweder aus einem flexiblen Material bestehen, welches in die Membranhalteplatte 44 eingelassen ist, oder durch einen entsprechenden, an der Membranhalteplatte 44 vorgesehenen Vorsprung gebildet sein.

Um bei einem angehobenen Oberwerkzeug 14 zu verhindern, dass die Stempel 60 aus den Führungskanälen herausfallen, kann die Sintervorrichtung 10 eine Sicherungsvorrichtung für die Stempel 60 aufweisen.

Gemäß einer Ausgestaltung einer derartigen Sicherungsvorrichtung können die Membran 50 bzw. die Membranabschnitte 50A magnetisch sein, was beispielsweise durch eine Beschichtung der Membran 50 bzw. der Membranabschnitte 50A mit einem ferromagnetischen oder paramagnetischen Material erreicht werden kann. Alternativ kann das magnetische Material auch in Form von Mikro- oder Nanopartikeln in die Membran 50 bzw. in die Membranabschnitte 50A eingebettet sein.

In die Stempel 60 sind in einer der Membran 50 zugewandten Stirnseiten jeweilige Magnetelemente 62 bevorzugt flächenbündig eingelassen. Diese aus einem temperaturbeständigen, permanentmagnetischen Material hergestellten Magnetelemente 62 treten mit der magnetischen Membran 50 in Wechselwirkung und verhindern somit ein Herausfallen der Stempel 60 aus den Führungskanälen 42. Für einen ggf. erforderlichen Austausch von Stempeln 60 können diese durch Aufwenden einer die Haltekraft überwindenden Kraft von der Membran 50 gelöst werden. Bei dieser Ausgestaltung kann die Stempelführungsplatte 46 auch einteilig ausgebildet sein.

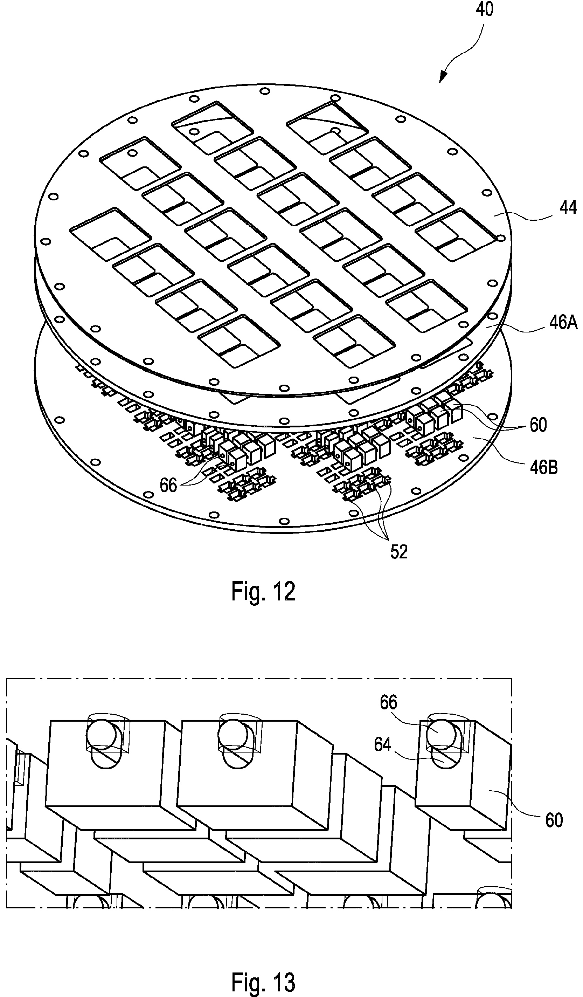

Mit Bezug nun auf Fig. 12 und 13 wird eine weitere Ausgestaltung des Führungsrahmens 40 beschrieben, welcher eine alternative Sicherungsvorrichtung für die Stempel 60 aufweist. Die Stempel 60 sind mit jeweiligen langlochartigen Ausnehmungen 64 versehen, durch welche hindurch sich längliche Sicherungsstifte 66 erstrecken. Die Sicherungsstifte 66 sind in kurzen Nuten 52 gehalten, welche an der Oberseite der unteren Stempelführungsplatte 46B ausgebildet sind. Um eine sichere Aufnahme der Sicherungsstifte 66 zu erhalten, können korrespondierende Nuten (nicht dargestellt) auch an der Unterseite der oberen Stempelführungsplatte 46A vorgesehen sein. Die Sicherungsstifte 66 können zwischen der oberen Stempelführungsplatte 46A und der unteren Stempelführungsplatte 46B geklemmt sein.

Die Ausnehmungen 64 in den Stempeln 60 sind derart bemessen, dass die für den Sintervorgang notwendige axiale Versetzbarkeit der Stempel 60 gegeben ist. Die Sicherungsstifte 66 können einen runden oder auch rechteckigen Querschnitt aufweisen. Ein jeweiliger Sicherungsstift 66 kann sich auch durch mehrere Stempel 60 hindurch erstrecken, wenn dies aus Platzgründen erforderlich ist.

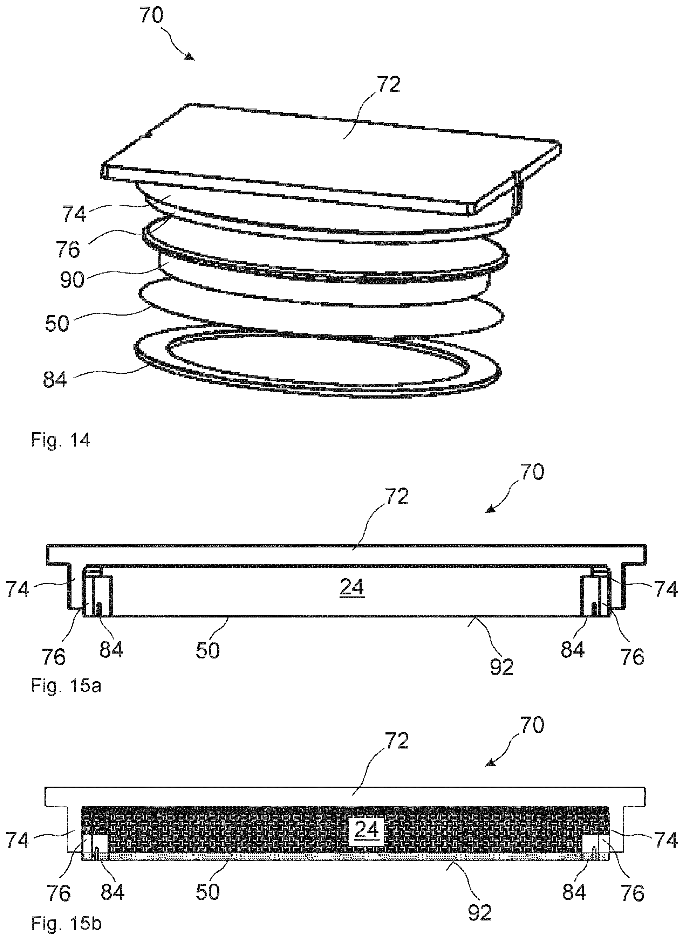

Gemäß einem weiteren Aspekt der Erfindung zeigen Fig. 14 und 15a bzw. 15b ein Presswerkzeug 70 für eine Ausführungsform einer Sintervorrichtung 10. Das Presswerkzeug 70 ist ohne Führungsrahmen 40 und Stempel 60 dargestellt, die in Richtung Pressfläche 92 hinzuzufügen wären. Das Presswerkzeug 70 kann sowohl als ein Oberwerkzeug als auch als ein Unterwerkzeug ausgestaltet sein und umfasst eine Grundplatte 72 und einen sich von der Grundplatte 72 weg erstreckenden zylinderförmigen Wandungsabschnitt 74. Die im Ausführungsbeispiel quadratische Form der Grundplatte 72 und die zylindrische Form des Wandungsabschnitts 74 sind rein beispielhaft und können jeweils auch abweichende Formen aufweisen.

Ein durch die Grundplatte 72 und den Wandungsabschnitt 74 definierter Hohlraum wird durch eine metallische Membrane 50 abgeschlossen. Die Membran 50 kann flach oder topfförmig, beispielsweise durch Tiefziehen aus einer Metallmembran oder einer Metallfolie hergestellt sein, wobei als bevorzugtes Material für die Membran 50 eine Stahllegierung, beispielsweise eine Chrom-Nickel-Stahllegierung, vorgesehen ist. Auf der Pressfläche 92 der Membran 50 können Stempel 60 angeordnet, beispielsweise magnetisch befestigt werden. Die Membran 50 umgrenzt den Hohlraum an seiner der Grundplatte 72 abgewandten Seite, in der beispielsweise ein Druckkissen 90 aufnehmbar ist. Alternativ kann im Hohlraum auch eine Stützstruktur, beispielsweise ein mechanisch weiches bzw. flüssiges Metall, eine Fluidkammer oder ein Silikonkissen aufgenommen sein. Die Membran 50 kann einen umlaufenden Randabschnitt aufweisen, welcher sich seitlich bis an den Wandungsabschnitt 74 erstreckt und der beispielswese zwischen der Grundplatte 72 und einem Klemmring 84 verklemmt. Der Klemmring 84 kann mit der Grundplatte 72 verschraubt sein, insbesondere am offenen Abschnitt des Wandungsabschnitts 74 befestigt sein, und kann den bevorzugt topfartigen Randabschnitt der Membrane 50 befestigten. Alternativ kann die Membrane 50 unmittelbar an den Wandungsabschnitt 74 befestigt werden. In einer in dem Klemmring 84 angeordneten Umfangsnut kann ein Ringkolben 76 eingelassen, welcher mit einer Innenumfangsfläche des Wandungsabschnitts 74 als Zylinder und mit dem Druckkissen 90 in oben beschriebener Weise zum Druckaufbau zusammenwirken kann.

Der zwischen der Grundplatte 72 und der Membran 50 ausgebildete Hohl-raum definiert einen allseitig abgeschlossenen Aufnahmeraum für ein Druckkissen oder eine Druckkammer 90. Dieser Aufnahmeraum kann beispielsweise ein mit einem Fluid, beispielsweise Silikon oder Öl, befüllte Druckkammer 90 ausbilden, oder ein Druckkissen 90 eingelegt sein, wobei das Druckkissen 90 beispielsweise ein Öl-befülltes Kissen oder ein Silikonkissen oder ähnliches sein kann. Das Druckkissen 90 kann beispielsweise Gewindeeinsätze aufweisen, welche es gestatten, das Druckkissen 90 mit der Grundplatte 72 zu verschrauben.

Die Dicke der Membran 50 ist derart gewählt, dass die Membran 50 im Bereich einer Pressfläche 92, welche mit den zu verbindenden Komponenten einer elektronischen Baugruppe über die nicht dargestellten Stempel 60 zusammenwirkt, eine ausreichende Elastizität aufweist, um sich um ein geeignetes Maß zu verformen und einen Druckausgleich zwischen benachbarten Komponenten über das Druckkissen 90 zu vermitteln. Die Membran 50 kann eine gleichförmige Dicke aufweisen, aber auch Bereiche variierender Dicke. So kann die Membran 50 bereichsweise verdickt oder verdünnt sein, und somit eine Strukturierung entsprechend unterschiedlichen Druckbereichszonen je nach Anordnungsstruktur von zu verpressenden Bauteilen 130 bzw. Anordnung von Stempeln 60 aufweisen. Die Größenverhältnisse in der Darstellung Fig. 14 und 15a, 15b sind nicht zwingend maßstäblich. Insbesondere kann die Dicke der Membran 50 auch kleiner als dargestellt sein. Auch können eine Vielzahl von Einzelmembranen 50a jeweils Durchbrechungsbereiche 48 eines Führungsrahmens 40 einzeln abdecken, wie dies in Fig. 5 dargestellt ist.

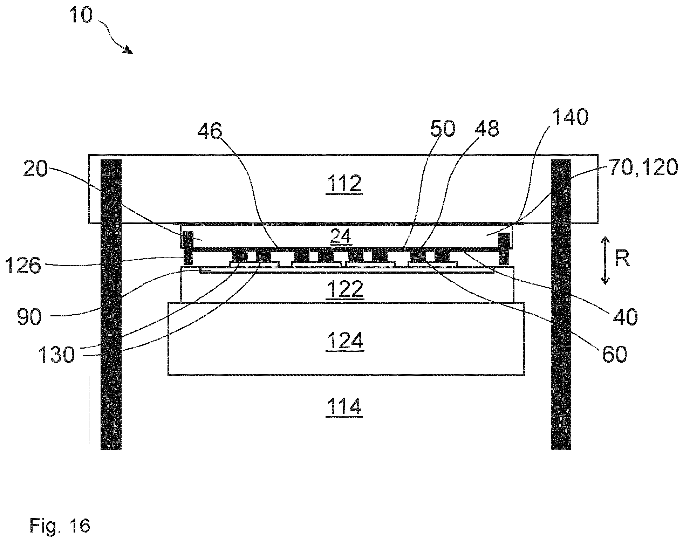

Mit Bezug auf Fig. 16 wird eine weitere Ausführungsform einer Sintervorrichtung 10 beschrieben, wobei die in diesem Zusammenhang beschriebenen Merkmale sowohl in Kombination mit den Merkmalen der vorstehend beschriebenen Sintervorrichtung 10 gemäß Figs. 1 bis 15 verwirklicht werden können als auch bei anderen, gattungsähnlichen Sintervorrichtungen zum Einsatz kommen können.

Die in Fig. 16 schematisch und nicht maßstäblich dargestellte Sintervorrichtung 10 umfasst ein Pressenjoch 112, der das Oberwerkzeug 120 aufnimmt, und einen unterhalb des Pressenjochs 112 vorgesehenen Pressstempel 114, der das Unterwerkzeug 122 aufnimmt, welche mittels eines Antriebs relativ zueinander in Richtung R versetzbar sind, um eine Presskraft auf die zwischen dem Oberwerkzeug 120 des Pressenjochs 112 und dem Unterwerkzeug 122 des Pressstempels 114 angeordneten zu verbindenden Komponenten / Bauelemente 130 einer elektronischen Baugruppe aufzubringen. Der Antrieb kann sowohl auf das Pressenjoch 112 als auch auf den Pressstempel 114 wirken und kann beispielsweise als hydraulische Presse mit einem Pressenantrieb 34 ausgeführt sein. An der Unterseite des Pressenjochs 112 ist ein oberes Pressenwerkzeug 70 als Oberwerkzeug 120, beispielsweise als Hart- oder Softwerkzeug angeordnet, wobei zwischen dem Pressenjoch 112 und dem Oberwerkzeug 120 eine Graphitfolie 140 vorgesehen ist, welche einen gewissen Druck- bzw. Gradientenausgleich zwischen dem Pressenjoch 112 und dem Oberwerkzeug 120 bewirken sowie ein paralleles Ausrichten und einen Höhenausgleich unterstützen kann. Die Graphitfolie 140 kann in Art und Dicke derart angepasst sein, dass sie im Sinne einer elastischen Folie beim Ausüben einer Presskraft zwischen Ober- und Unterwerkzeug eine planbare Ausrichtung zwischen oberem Hartwerkzeug 120 und einem Unterwerkzeug 122 erreichen kann. Somit ist eine exakte parallele Ausrichtung von Ober- und Unterwerkzeug mittels der Graphitfolie 140 herstellbar.

Das Oberwerkzeug 120 kann ein Hartwerkzeug sein, oder kann ein Softwerkzeug mit einem elastischen Sinterkissen 24 sein. Als Oberwerkzeug 120 bietet sich ein zuvor beschriebenes Oberwerkzeug 14 oder das in den Figs. 15a, Fig. 15b gezeigte Presswerkzeug 70 bzw. eine Kombination daraus an. In Fig. 16 ist exemplarisch als Oberwerkzeug 120 ein Pressenwerkzeug 70 mit umlaufenden Ringkolben 126 zur Verpressung eines Sinterkissens 24 dargestellt, wobei das Sinterkissen 24 auf einzelne Stempel 60, geführt in Durchbrechungen 48 einer Stempelführungsplatte 46 über eine Membran 50 wirkt. Die Stempel 60 sind dabei auf die zu sinternden Bauelemente 130 ausgerichtet.

Auf der Oberseite des Pressstempels 114 befindet sich eine Heizplatte 124, welche neben einer oder mehrerer Heizvorrichtungen auch eine oder mehrere Kühlvorrichtungen aufweisen kann. Auf der Oberseite der Heizplatte 124 ist das Unterwerkzeug 122 angeordnet, welches an seiner Oberfläche eine Aufnahme für ein elastisches Drucckissen 90 aufweist. Alternativ oder zusätzlich kann im oberen Werkzeug 120 ein Druckkissen 24 in einer Ausführung als Softwerkzeug vorgesehen sein, so kann das obere Hartwerkzeug 120 und / oder das Unterwerkzeug 122 durch ein Presswerkzeug 70, wie in den Figs. 14, 15a oder 15b dargestellt, ersetzt werden.

Auf dem Druckkissen 90 sind die zu verbindenden Komponenten oder Bauelemente 130 angeordnet. Im Oberwerkzeug ist ein Pressenwerkzeug 70 mit einer durchgängigen Metallmembran 50 sowie in Durchbrechungen 48 eines Führungsrahmen geführte Stempel 60 angeordnet, die auf Bauteile 130 eine Sinterpresskraft ausüben können. Optional kann eine oder mehrere Trennfolien unter- und oberhalb der Bauelemente 130 vorgesehen sein, um ein Anhaften an dem Druckkissen 90 bzw. den Stempeln 60 zu verhindern.

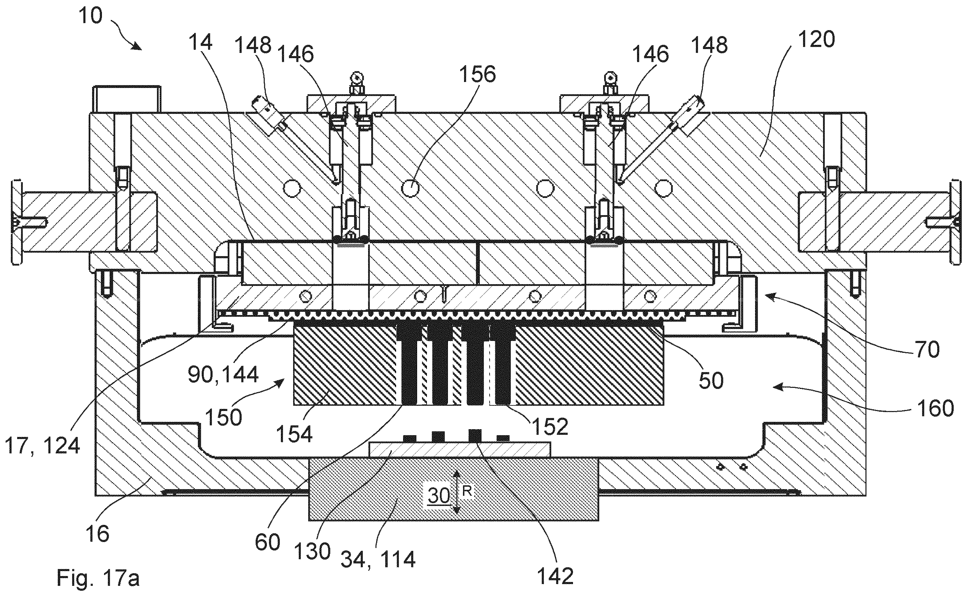

Die Figs. 17a bis 17c zeigen eine Ausführungsform einer Diffusionslöt- und/oder Sintervorrichtungen 10 mit einer einzelnen Baugruppe 12 mit einem Bauelement 130 in Kombination mit einem Pressenwerkzeug 70, wie es beispielsweise in der Fig. 8 dargestellt ist. Die Prozesskammer 160 umfasst ein Oberwerkzeug 14 und ein Unterwerkzeug 16. Das Oberwerkzeug 14 ist in einem Pressenjoch 120umfasst.

Im Unterwerkzeug 16 ist eine Pressenantrieb 34 angeordnet, der über einen Pressenstempel 114 einen Vorschub auf ein, in einem nicht dargestellten Werkstückträger aufgenommen, Bauelement 130 relativ zum im Oberwerkzeug 14 angeordneten Pressenwerkzeug 70 ausüben kann. Auf dem Bauelement 130 der Baugruppe 12 sind mehrere Bauteile 142, beispielsweise Leistungshalbleiterbauteile wie IGBTs oder ähnliches angeordnet. Die Bauteile 142 des Bauelements 130 können unterschiedliche Höhen aufweisen und sollen in einem Diffusionslöt-, Bond-, oder Sinterprozess auf dem Bauelement 130 verbunden werden, beispielsweise mit einer Kühlstruktur und Anschlussleitungen. Hierzu kann das Bauelement 130 zur Vermeidung von Verschmutzungen und zum Schutz mit einer, nicht dargestellten, Prozessabdeckung, beispielsweise einer Folie oder ähnlichem abgedeckt sein. Im Pressenjoch 120 sind Fluidkanäle 156 zur Temperierung, d.h. zur Führung eines Heiz- oder Kühlfluids wie Öl oder Luft integriert.

Im Pressenwerkzeug 70 ist eine Heizplatte 124 als Heizvorrichtung 17 angeordnet, die ebensolche Fluidkanäle zur Beheizung bzw. Abkühlung aufweisen kann. Nach unten begrenzt die Heizplatte 124 eine Druckkammer 90, in der ein Druckkissen eingelegt sein kann. Die Druckkammer 90 weist einen Kammerbereich 144 auf, der steuerbar mit Fluid befüllbar ist. Das Fluid kann ein Gas oder eine Flüssigkeit sein. In dieser Ausführungsform ist vorgesehen, den Kammerbereich 144 mit Atmosphärengas der Prozesskammer 160 zu füllen, beispielsweise mit einem Reinigungsgas wie Stickstoff oder mit Luft. Hierzu sind im Pressenjoch 120 zwei Füllventile 146 vorgesehen, die über Ventilaktuatoren 148 ein fluiddichtes Verschließen oder Öffnen des Kammerbereichs 144 der Druckkammer 90 gegenüber der Prozesskammer 160 ermöglicht.

Die Druckkammer 90 wird weiterhin in Richtung Unterwerkzeug mit einer Metallmembran als Membran 50 begrenzt. Die Metallmembran kann beispielsweise eine Stahlmembran, z.B. ein topfförmig ausgeformtes Stahlblech sein. Durch eine Fluidbefüllung des Kammerbereichs 144 kann die Metallmembran nach unten in Richtung Prozesskammer 160 ausgewölbt werden.

Unterhalb der Membran 50 ist eine Multistempeleinheit 150 angeordnet. Die Multistempeleinheit 150 umfasst eine Führungsplatte 154, die mehrere Pressstempel 152 aufnimmt und führt. Die Pressstempel 152 dienen zur selektiven Presskrafteinleitung in vordefinierbare Bereiche des Bauelements 130, und können von Form und Größe den verschiedenen geometrischen Abmessungen der Bauteile 142 angepasst sein, in die Presskraft eingeleitet werden soll. Bei einer Druckbeaufschlagung, d.h. einer Aktivierung des Pressenantriebs 34 werden die Pressstempel 152 innerhalb des Führungsrahmens 154 in Richtung Bauelement 130 zur selektiven Presskraftausübung versetzt.

In dem in den Figs. 17a bis 17c dargestellten Ablauf soll - unabhängig von einer Presskrafterzeugung durch den Pressenantrieb 34 - eine Druckbeaufschlagung durch eine Auswölbung der Membran 50 aufgrund einer Druckdifferenz zwischen Prozesskammer 160 und fluidbefüllbaren Kammerbereichen 144 der Druckkammer 90 erfolgen. Die Größe der Druckkraft wird vom Druckunterschied zwischen Kammerbereich 144 und Prozesskammer 160 bestimmt, dieser bedingt eine Verdrängung der Membran 50 in Richtung Unterwerkzeug 16 und übt dadurch einen Druck auf das Bauelement 130 aus.

In einem ersten Prozessschritt, dargestellt in Fig. 17a, sind die Fluidventile 146 in einer oberen Stellung, so dass der Kammerbereich 144 in Fluidverbindung mit der Prozesskammer 160 stehen. Im zweiten Prozessschritt wird die Prozesskammer 160 vakuumiert, dies führt auch zur Vakuumierung des Kammerbereichs 144. Der erste und zweite Prozessschritt ist in Fig. 17a dargestellt.

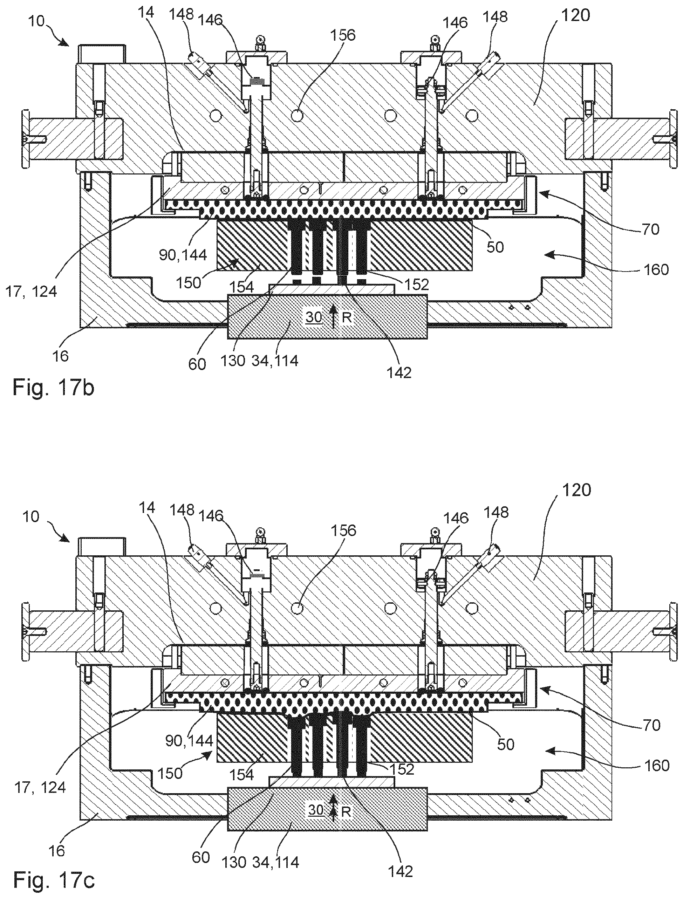

Im nachfolgenden dritten Prozessschritt wird die Prozesskammer 160 mit einem Reinigungsgas wie Stickstoff geflutet, das in den Kammerbereich 144 der Fluidkammer 90 eindringt. Anschließend wird im vierten Prozessschritt die Füllventile 146 mittels der Ventilaktuatoren 148 fluiddicht von der Prozesskammer 160 getrennt. Hiernach wird im fünften Prozessschritt der Pressenantrieb 34 soweit aktiviert, bis ein Werkstückträger (nicht dargestellt) mit dem Bauelement 130 und einer aufgelegten Prozessabdeckung (ebenfalls nicht dargestellt) an der Multistempeleinheit 154 benachbart anliegt. Die Schritte Drei bis Fünf sind in Fig. 17b gezeigt.

Im anschließenden sechsten Prozessschritt, dargestellt in Fig. 17c, wird die Prozesskammer 160 evakuiert. Dabei wölbt sich die Membran 50 aufgrund der Druckdifferenz zwischen Kammerbereich 144 der Druckkammer 90 und Prozesskammer 160 nach unten, und versetzt die Pressstempel 152 innerhalb dem Führungsrahme 154 in Richtung Bauelement 130, so dass auf den einzelnen Bauteilen 142 selektiv Druckkraft ausgeübt wird. Dabei können Höhenunterschiede der Bauteile 142 ausgeglichen werden, wobei abhängig von der Druckdifferenz die Presskraft fein dosierbar ist.

Diese aus der Druckdifferenz zwischen Prozesskammer 160 und Druckkammer 90 resultierende Druckbeaufschlagung kann alternativ oder zusätzlich zu einer durch den Pressenantrieb 34 ausgeübten Presskraft aufgebracht werden. Die hierdurch erzeugbare Drücke sind in der Regel geringer und feiner dosierbar als die mechanische Druckkraftbeaufschlagung mittels des Pressenantriebs 34. Hiermit kann ein Bondingverfahren, Diffusionslötverfahren oder Niederdrucksinterverfahren effektiv unterstützt werden.

In den Figs 18a, 18b sind zwei Ausführungsformen von abgedichteten Pressstempeln 152 dargestellt. In der Fig. 18a ist ein Pressenstempel 152 aus einem Hartmaterial wie Stahl axial in einem Führungskanal 42 eines Führungsrahmens 40 gelagert und geführt. Oberhalb des Führungsrahmens 40 ist ein Druckkissen 24, z.B. aus Silikon und/oder eine unter Druck setzbare Druckkammer 90 angeordnet, die durch den Führungsrahmen 40 und den in Richtung des Druckkissens 24 bzw. der Druckammer abgedichteten Pressenstempel 152 abgedichtet ist. Der Pressenstempel 152 weist eine, einem zu verpressenden Bauelement 12B zugewandte Stempelunterseite 170 und eine dem Druckkissen 24 bzw. der Druckkammer 90 zugewandte Stempeloberseite 168 auf. Die Querschnittsform des Pressenstempels 152 kann vorzugsweise quadratisch oder rechteckig sein und kann abgerundete Eckenbereiche aufweisen, so dass zumindest eine Stempeluntersite 170 einer Größe eines zu verpressenden Bauelements 12B anpassbar ist. Der axiale Umfang des Pressenstempels 152 weist eine an der Innnenfläche des Führungskanals 42 anliegende Stempel-Führungsseite 162 auf, und diese weist im Bereich der Stempeloberseite 168 einen Stempel-Führungsseitenabschnitt 164 auf. Der Stempel-Führungsseitenabschnitt 164 kann radial rückspringend ausgebildet sein, und entlang seines Umfangs im Sinne eines Dichtungseinsatzes ein Gleitführungselement 166 aufnehmen, um den Rücksprung auszufüllen. Das Gleitführungselement 166 kann bevorzugt aus einem thermoresistenten Kunststoff, Silikon oder sonst einem weicheren Material als das Material des Pressenstempels 152 bestehen, insbesondere einem Material mit höherem thermischen Ausdehnungskoeffizienten als das Stempelmaterial. Ein geeignetes Material ist z.B. ein Hochtemperatur-Thermoplast, insb. ein Polyetheretherketon oder Polyimid, das unter der Markenbezeichnung PEEK, Tecapeek oder Vespel vertrieben wird. Des Weiteren können Materialien, insbesondere Kunststoffe, mit hohen elektrischer und thermischer Leitfähigkeit, die z.B. Graphit umfassen, eingesetzt werden. Vorzugsweise ist das Gleitführungselement 166 entlang des Stempel-Führungsseitenabschnitts 164 aufgespritzt oder über ein 3D-Druckverfahren unmittelbar aufgedruckt. Am Übergang der Oberseite des Gleitführungselement 166 zur Stempeloberseite 168 ist in der Stempeloberseite 168 eine vorzugsweise umlaufende Stempelnut 174 eingelassen, wodurch das Druckkissen 24 eindringen und bei eine thermischen Ausdehnung durch Erwärmung des Pressenstempels 152 die Oberseite des Gleitführungselement 166 in Richtung der Zylinderwandung des Führungskanals 42 verdrängt und somit verbessert abdichtet.

In dem Ausführungsbeispiel der Fig. 18a ist die Fläche der Stempelunterseite 170 gegenüber der Fläche der Stempeloberseite 168 verkleinert, so dass der Pressdruck erhöht werden kann. Im Gegensatz dazu ist in der Fig. 18b ein Ausführungsbeispiel eines Pressenstempels 152 dargestellt, dessen Stempelunterseite 170 gegenüber der Stempeloberseite 168 vergrößert ist, um den Pressdruck herabzusetzen bzw. eine vergrößerte Fläche eines Bauelements 12B verpressen zu können.

Ebenfalls ist in einer vergrößerten Darstellung in Fig. 18b ein teilperspektivische Querschnittsdarstellung des Gleitführungseinsatzes 166 dargestellt. An der der Zylinderwandung des Führungskanals 42 zugewandten Seite weist das Gleitführungselement 166 eine reibmindernde Oberflächenkontur 176, z.B. eine Rillenkontur, auf, so dass die Reibung bei einer axialen Bewegung des Pressenstempels 152 gegenüber der Außenwandung des Führungskanals 42 verringert ist.

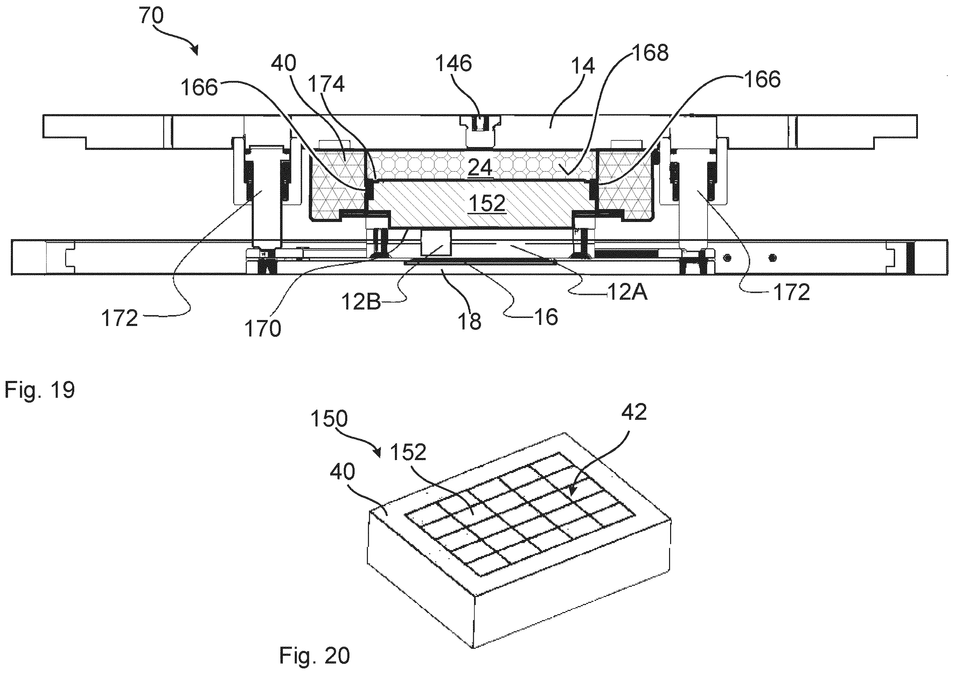

Die Fig. 19 zeigt eine weitere Ausführungsform eines Pressenwerkzeugs 70, in der exemplarisch ein wie in Fig. 18a dargestellter Pressenstempel eingesetzt ist. In der Regel ist eine Mehrzahl derartiger Pressenstempel in einer gemeinsamen oder in mehreren Führungsrahmen in dem Pressenwerkzeug 70 aufgenommen. Das Pressenwerkzeug weist ein Oberwerkzeug 14 und ein Unterwerkzeug 16 auf. Im Unterwerkzeug 16 kann ein Werkstückträger 18 aufgenommen sein. Auf dem Werkstückträger 18 kann als zu verbindende Baugruppe 12 ein Substrat 12A und ein Bauelement 12B angeordnet sein. Optional kann eine Prozessabdeckung, z.B. eine temperaturbeständige Folie als Abdeckung temporär während des Sinter- bzw. Pressvorgangs (nicht dargestellt) zwischen der Baugruppe 12 und dem Oberwerkzeug 14 angeordnet werden.

Das Oberwerkzeug 18 umfasst einen Führungsrahmen 40, der einen oder eine Mehrzahl von in Führungskanälen 42 aufgenommen, Pressenstempeln 152 umfasst. Der Führungsrahmen dichtet ein darüber befindliches Druckkissen 24 gegenüber der Baugruppe 12 ab. Das Druckkissen 24 bzw. eine Druckkammer 90 kann über ein Füllventil 146 unter Druck gesetzt bzw. druckentlastet werden. Zwei oder mehrere Positionierungselemente 172, z.B. Indizierungsstangen dienen zum Positionieren des Oberwerkzeugs 14 gegenüber dem Unterwerkzeug 14 und zum Fixieren einer Prozessabdeckung. Die Positionierungselement 172 könne über eine nicht dargestellte Verfahreinheit ein- und ausgefahren werden.

Das Unterwerkzeug 16 kann ein Transportrahmen zum Aufnehmen eines Werkstückträgers 18 umfassen, der auf einer nicht dargestellten Transporteinheit automatisch durch die Sintervorrichtung 10 transportierbar ist. Der Werkstückträger kann im Unterwerkzeug 16 eingesetzt und entfernt werden. Der Transportrahmen kann aus einem elektrisch leitenden, druckhartem Material wie Edelstahl bestehen, der beispielsweise Verbindungsleisten aus gewichtsreduziertem, ebenfalls elektrisch leitendem Material wie einer Aluminiumlegierung aufweisen kann.

Daneben stellt Fig. 20 in einer perspektivische Darstellung eine Ausführungsform einer Multistempeleinheit 150 vor, wie sie in einem Pressenwerkzeug 70 eingesetzt werden kann. In der Regel wird jeder Pressenstempel 152 in einem Führungskanal 42 eines Führungsrahmens 40 geführt. In dieser Ausführungsform werden mehrere Pressenstempel aneinander und in einem gemeinsamen Führungskanal 42 axial geführt. Die Pressenstempel sind dabei gegeneinander axial versetzbar. Eine Abdichtung gegenüber einer nicht dargestellten Druckkammer 90 bzw. einem Druckkissen 24 kann über eine vorab beschriebene Membran 50 bzw. Membranabschnitte 50A oder über Gleitführungseinsätze 166, die für jeden Pressstempel 152 vorgesehen sind, erfolgen. Vorteilhaft kann eine Metallmembran verwendet werden, wobei die einzelnen Pressstempel 152 magnetisch an der Metallmembran kraftschlüssig befestigbar sind. Die Multistempeleinheit 150 ermöglicht mit angepassten Längen und Größen der einzelnen Pressenstempel 152 das Verpressen bzw. Sintern von Baugruppen 12 mit eng benachbarten, verschieden hohen Strukturen. Auch kann auf einem Unterwerkzeug 16 eine druckstabile Maske aufgelegt sein, die ein Durchtauchen einzelner Pressstempel 152 erlaubt, und andere Pressstempel 152 zurückhält. Somit kann eine flexible Anpassung an verschiedene Baugruppen 12 durch den Einsatz einer Druckmaske auf dem Unterwerkzeug 16 statt eine Anpassung des Führungsrahmens 40 des Oberwerkzeugs erfolgen, so dass insbesondere für Kleinserien eine flexible und kostengünstige Anpassung an variierende Press- bzw. Sinteraufgaben ermöglicht wird. Es bietet sich an, eine Multistempeleinheit 150 anstelle eines Einzelstempels 152 in das in den Figs. 18a, 18b dargestellte Konzept einer Stempelabdichtung einzusetzen. Anstellen des in den Figs. 18a, 18b dargestellten Einzelstempels 152 können somit eine Mehrzahl kleiner Einzelstempel 152, die vorzugsweise über eine Metallmembran auf der Stempeloberseite 168 gegenüber dem Druckkissen 24 abgedichtet sind, eingesetzt werden. Die Einzelstempel 152 können magnetisch an der Metallmembran anhaften. Somit können mittels kleiner Einzelstempel 152 einer Multistempeleinheit 150 sehr kleine Bauteilgrößen von wenigen Millimetern, z.B. von 5 mm Kantenlänge oder kleiner eines komplexen Bauteils 142 auf einem Bauelement 130 verpresst werden, bei denen eine Einzelabdichtung der kleinen Einzelstempel 152 nicht oder nur erschwert möglich wäre .

Schließlich zeigen Figs. 21a, 21b ein Ausführungsbeispiel eines quadratischen Kolbens 30 als Ringkolben 76 mit einem Druckkissen 24 als Silikonkissen eines Ausführungsbeispiels. Durch die quadratische Form der sich als untere Druckkissenseite 180 ausbildendende Stempelfläche können platzsparend und der üblichen Form der Baugruppen, insbesondere Leistungshalbleiter wie IGBTs, angepasste Stempelformen bereitgestellt werden. Die seitlichen Kanten der Führungsseiten des Ringkolbens 76 sind abgerundet, um Spannungsspitzen im Bereich der Zylinderwandung zu vermeiden und um die Dichtwirkung des Kolbens 30 im Zylinder 28 bereitzustellen. Fig. 21a zeigt eine Draufsicht und eine Schnittansicht A-A eines Kolbens 30 als rechteckförmigen Ringkolben 76 mit abgerundeten seitlichen Kanten bzw. Führungsseiten. Der Kolben 30 umfasst einen Kolbenmantel 184 aus einem harten Material wie beispielsweise Stahl und einen darin formschlüssig eingeschobenen Kolbendichtdichteinsatz 186 aus einem weichen Material, bevorzugt Kunststoff. Das weiche Material unterstützt ein paralleles Ausrichten des Stempels 60 gegenüber der Oberfläche des Bauteils 130 bzw. der Baugruppe auf dem Unterwerkzeug 16. Die Schnittdarstellung A-A zeigt einen Schnitt durch den Kobeln 30 in der angegebenen Blickrichtung der Draufsicht nach oben geklappt. Der Kolben 30 weist eine Kolbenoberseite 198 auf, durch die der in Fig. 21b dargestellte Softkissen 24, das zugleich einen Stempel 60 als Softstempel ausbildet, durchtaucht und auf einer Kolbenunterseite 196 unter Einschieben des Kolbens 30 in ein nicht dargestellten Zylinder 28 austritt, da der Kolben 30 das Volumen des Druckkissens 24 durch Abstützen auf der Baugruppe 12, einem Werkstückträger 18 oder dem Unterwerkzeug 16 bei gleichzeitigem Zufahren von Oberwerkzeug 14 auf Unterwerkzeug 16 verringert. Auf der Kolbenoberseite 198 weist der Kolbenmantel 184 des Ringkolbens 76 einen Dichtungssitz 200 in Form einer hervorstehenden umlaufenden Kante auf. Durch formschlüssiges Einschieben des Kolbendichteinsatzes 186 von der Kolbenoberseite 198 wird eine Dichtungsnut 188 ausgebildet. Diese wird auf Seiten des Kolbendichteinsatzes 186 durch einen Flanschbereich 190, der in den Dichtungssitz 200 aufsitzt, begrenzt. Ein weiches Druckkissen 24 dringt bei Druckbeaufschlagung in die Dichtungsnut 188 ein, und verhindert ein Eindringen des Druckkissens in einen Spalt zwischen Kolben 30 und Zylinder 28. Die umlaufenden oberen Kanten um die Oberseite 198 des Ringkolbens 76, insbesondere entlang des Dichtungssitzes 200 sind scharfkantig, um die Dichtwirkung zu verbessern, während die umlaufenden unteren Kanten auf der Unterseite 196 des Ringkolbens 76 abgerundet sind, um Spannungsspitzen zum Bauteil bzw. der Baugruppe zu vermeiden.

In der Fig. 21b zeigt in einer Bodenansicht und Schnittansicht B-B ein Druckkissen 24, das in diesem Ausführungsbeispiel als Stempel 60, als sogenannter Softstempel ausgeführt ist. Die Schnittdarstellung B-B ist als nach unten geklappte Darstellung entlang der Schnittlinie B-B der oberen Bodenansicht zu verstehen. Das Druckkissen 24 kann als Silikonstempel ausgebildet sein, und kann in seinem inneren eine Ausnehmung für eine harte Stempeleinlage, z.B. einem Metallklotz bieten. Die Unterseite 180 des Druckkissens kann eine Stempelpressfläche ausbilden. Auf der Oberseite 182 des Druckkissens ist ein Dichtrand 192 ausgebildet. Nach einer ersten Pressverwendung bildet sich durch die Verdrängung des Materials des Dichtrands 192 des Druckkissens 24 in die Dichtungsnut 188 des Kolbens 30 eine Dichtnaht 194, die effektiv eine Abdichtung der Oberseite 182 des Druckkissens gegenüber dem Kolben 30 und dem Zylinder 28 (nicht dargestellt) ermöglicht.

### BEZUGSZEICHENLISTE

- 10: Sintervorrichtung
- 12: Baugruppe
- 12A: Substrat
- 12B: Bauelement
- 14: Oberwerkzeug
- 16: Unterwerkzeug
- 17: Heizvorrichtung
- 18: Werkstückträger
- 20: Druckeinheit
- 22: Aufnahme
- 24: Druckkissen
- 26: Öffnung
- 28: Zylinder
- 30: Kolben
- 32: Folienhaltering
- 34: Presseantrieb

- 40: Führungsrahmen
- 42: Führungskanal
- 44: Membranhalteplatte
- 46: Stempelführungsplatte
- 46A: obere Stempelführungsplatte
- 46B: untere Stempelführungsplatte
- 48: Durchbrechung
- 50: Membran
- 50A: Membranabschnitt
- 52: Nut
- 54: Vertiefung
- 56: Dichtrand
- 60: Stempel
- 62: Magnetelement
- 64: Ausnehmung
- 66: Sicherungsstift
- 70: Presswerkzeug
- 72: Grundplatte
- 74: Wandungsabschnitt
- 76: Ringkolben
- 84: Klemmring
- 90: Druckkissen
- 92: Pressfläche
- 112: Pressenjoch
- 114: Pressstempel
- 120: Oberwerkzeug
- 122: Unterwerkzeug
- 124: Heizplatte
- 126: Ringkolben
- 130: Bauelement, Komponente
- 140: elastische Folie / Graphitfolie
- 142: Bauteil auf Bauelement
- 144: befüllbarer Kammerbereich der Fluidkammer
- 146: Füllventil
- 148: Ventilaktuator
- 150: Multistempeleinheit
- 152: Pressstempel
- 154: Führungsrahmen
- 156: Fluidkanäle zur Temperierung
- 160: Prozesskammer
- 162: Stempel-Führungsseite
- 164: Stempel-Führungsseitenabschnitt
- 166: Gleitführungseinsatz
- 168: Stempeloberseite
- 170: Stempelunterseite
- 172: Positionierungselement
- 174: umlaufende Stempelnut
- 176: reibmindernde Oberflächenkontur
- 180: Druckkissen-Unterseite
- 182: Druckkissen-Oberseite
- 184: Kolbenmantel
- 186: Kolbendichteinsatz
- 188: Dichtungsnut
- 190: Dichteinsatz-Flanschbereich
- 192: Druckkissen-Dichtrand
- 194: Druckkissen-Dichtnaht
- 196: Kolbenunterseite
- 198: Kolbenoberseite
- 200: Kolbenmantel-Dichtungssitz

- R: Pressrichtung

## Patentansprüche

1. Diffusionslötvorrichtung und/oder Sintervorrichtung (10) zum Verbinden von Komponenten zumindest einer elektronischen Baugruppe (12) mittels Diffusionslöten und/oder Drucksintern, mit einem Oberwerkzeug (14, 120) und einem Unterwerkzeug (16, 122), zwischen denen die zumindest eine Baugruppe (12) aufgenommen ist, wobei das Oberwerkzeug (14, 120) zumindest ein mit einem Fluid bzw. verdrängbarem Medium befülltes oder befüllbares Druckkissen (24, 90), dessen Innendruck veränderbar ist, und zumindest einen, insbesondere mehrere, mit dem Druckkissen (24, 90) in Wirkverbindung stehende Stempel (60, 152) aufweist, welche zum Übertragen einer durch eine Druckerhöhung im Druckkissen (24, 90) erzeugten Presskraft auf die Baugruppe (12) eingerichtet sind, wobei das Oberwerkzeug (14, 120) einen Führungsrahmen (40, 154) aufweist, in welchem der oder die die Stempel (60, 152) axial entlang der Wirkrichtung der Presskraft versetzbar geführt sind, wobei der oder die Stempel (60, 152) in dem Führungsrahmen (40, 154) gegenüber dem Druckkissen (24, 90) abgedichtet versetzbar geführt sind, wobei das Oberwerkzeug (14, 120) zumindest eine Druckeinheit (20) mit einer Aufnahme (22) für das Druckkissen (24 90) aufweist, **dadurch gekennzeichnet, dass** die Druckeinheit (20) einen Zylinder (28) und einen darin versetzbar aufgenommenen Kolben (30) aufweist, wobei der Zylinder (28) und der Kolben (30) die Aufnahme (22) für das Druckkissen (24, 90) derart definieren, dass durch ein Versetzen des Kolbens (30) das Volumen der Aufnahme (22) veränderbar ist.

2. Diffusionslötvorrichtung und/oder Sintervorrichtung (10) nach Anspruch 1,
wobei die Druckeinheit (20) eine dem Unterwerkzeug (16, 122) zugewandte Öffnung (26) aufweist, welche von dem Führungsrahmen (40, 154) überdeckt wird, wobei das Druckkissen (24, 90) auf dem Führungsrahmen (40, 154) aufliegt.

3. Diffusionslötvorrichtung und/oder Sintervorrichtung (10) nach Anspruch 2,
wobei die Öffnung (26) in dem Kolben (30) vorgesehen ist.

4. Diffusionslötvorrichtung und/oder Sintervorrichtung (10) nach Anspruch 1 oder 3,
wobei das Oberwerkzeug (14, 120) und das Unterwerkzeug (16, 122) relativ zueinander entlang der Wirkrichtung der Presskraft versetzbar sind, wobei der Kolben (30) bei einem Aufsetzen des Oberwerkzeugs (14, 120) auf dem Unterwerkzeug (16, 122) oder auf einem auf dem Unterwerkzeug (16, 122) aufliegenden Werkstückträger in den Zylinder (28) versetzt wird.

5. Diffusionslötvorrichtung und/oder Sintervorrichtung (10) nach einem der vorhergehenden Ansprüche, wobei das Druckkissen (24 90) mit einer Fluidquelle zur Zufuhr von Fluid in das Druckkissen (24 90) verbunden oder verbindbar ist, wobei die Druckerhöhung durch die Zufuhr von Fluid bewirkbar ist.

6. Diffusionslötvorrichtung und/oder Sintervorrichtung (10) nach einem der vorhergehenden Ansprüche, wobei der Führungsrahmen (40, 154) eine Stempelführungsplatte (46) umfasst, welche Führungskanäle (42) zur axialen Führung des bzw. der Stempel (60, 152) aufweist.

7. Diffusionslötvorrichtung und/oder Sintervorrichtung (10) nach Anspruch 6, wobei zwischen dem Druckkissen (24, 90) und dem bzw. den Stempeln (60, 152) zumindest eine flexible Membran (50, 50A) angeordnet ist, welche die Führungskanäle (42) überdeckt.

8. Diffusionslötvorrichtung und/oder Sintervorrichtung (10) nach Anspruch 7,
wobei der Führungsrahmen (40, 154) eine Membranhalteplatte (44) aufweist, welche auf einer dem Druckkissen (2490) zugewandten Seite der Stempelführungsplatte (46) angeordnet ist, wobei die Membran (50, 50A) zwischen der Membranhalteplatte (44) und der Stempelführungsplatte (46) gehalten ist.

9. 4A-Diffusionslötvorrichtung und/oder Sintervorrichtung (10) nach Anspruch 8, wobei die Membranhalteplatte (44) zumindest eine Durchbrechung (48) aufweist, welche sich zumindest über die Führungskanäle (42) erstreckt.

10. Diffusionslötvorrichtung und/oder Sintervorrichtung (10) nach einem der Ansprüche 7 bis 9, wobei der oder die Stempel (60, 152) dauerhaft oder lösbar mit der Membran (50, 50A) verbunden, bevorzugt verklebt sind.

11. Diffusionslötvorrichtung und/oder Sintervorrichtung (10) nach einem der Ansprüche 6 bis 10, wobei das Oberwerkzeug (14, 120) zumindest eine Sicherungsvorrichtung für den oder die Stempel (60, 152) aufweist, welche der oder die Stempel (60, 152) gegen ein Herausfallen des oder der Stempel (60, 152) aus den Führungskanälen (42) sichert.

12. Diffusionslötvorrichtung und/oder Sintervorrichtung (10) nach Anspruch 10 und 11,
wobei die Membran (50, 50A) magnetisch ist, und dass die Sicherungsvorrichtung jeweilige mit dem oder den Stempeln (60, 152) verbundene, bevorzugt in den oder die Stempel (60, 152) integrierte Magnetelemente (62) umfasst, welche den oder die Stempel (60, 152) an der Membran (50, 50A) halten.

13. Diffusionslötvorrichtung und/oder Sintervorrichtung (10) nach Anspruch 11 oder 12,
wobei die Sicherungsvorrichtung jeweilige Sicherungsstifte (66) umfasst, welche in der Membranhalteplatte (44) gelagert sind und sich durch in dem Stempel (60, 152) oder den Stempeln (60, 152) vorgesehene Ausnehmungen (64) hindurch erstrecken.

14. Diffusionslötvorrichtung und/oder Sintervorrichtung (10) nach einem der Ansprüche 6 bis 13, wobei der bzw. die Stempel (60, 152) mit seitlichem Spiel in den Führungskanälen (42) aufgenommen sind.

15. Diffusionslötvorrichtung und/oder Sintervorrichtung (10) nach einem der vorgenannten Ansprüche, wobei der oder die Stempel (60, 152) einen quadratischen oder rechteckigen Querschnitt aufweisen, wobei bevorzugt die Führungsseiten (162) der Stempel (60, 152) abgerundet sind.

16. Diffusionslötvorrichtung und/oder Sintervorrichtung (10) nach Anspruch 6 und 15,
wobei der Führungsrahmen (40, 154), insbesondere die Stempelführungsplatte (46), eine quadratische oder rechteckige Form besitzt, und die Führungskanäle (42) eine quadratische oder rechteckige Querschnittsform aufweisen.

17. Diffusionslötvorrichtung und/oder Sintervorrichtung (10) nach Anspruch 6,
wobei ein oder mehrere Führungskanäle (42) eine Mehrzahl von benachbarten Stempeln (60, 152) aufnimmt, die bevorzugt an sich selbst führbar sind.

18. Diffusionslötvorrichtung und/oder Sintervorrichtung (10) nach einem der vorgenannten Ansprüche, wobei der oder die Stempel (60, 152) auf einem dem Druckkissen (24, 90) zugewandten oberen Führungsseitenabschnitt (164) eine Gleitführungseinsatz (166) aus einem weicheren Material als das Stempelmaterial, bevorzugt Kunststoff, aufweisen, wobei bevorzugt auf der Stempeloberseite (168) eine umlaufende Stempelnut (174) zwischen der Oberkante des Gleitführungseinsatzes (166) und der Stempeloberseite (168) vorgesehen ist.

19. Diffusionslötvorrichtung und/oder Sintervorrichtung (10) nach einem der vorgenannten Ansprüche, wobei der oder die Stempel (60, 152) auf der Stempelunterseite (170) einen kleineren oder größeren Querschnitt als auf der Stempeloberseite (168) aufweist.

20. Diffusionslötvorrichtung und/oder Sintervorrichtung (10) nach einem der vorgenannten Ansprüche 1 bis 4, wobei der Kolben (30) gegenüber dem Zylinder (24, 90) abgedichtet versetzbar geführt ist, wobei bevorzugt der Kolben (30) als Ringkolben (76, 126) ausgeformt ist, und bevorzugt einen Kolbenmantel (184) aus einem härteren Werkstoff, insbesondere Stahl, und einen formschlüssig in den Kolbenmantel (184) aufgenommenen Kolbendichteinsatz (186) aus einem weicheren Werkstoff, insbesondere Kunststoff umfasst.

21. Diffusionslötvorrichtung und/oder Sintervorrichtung (10) nach Anspruch 20,
wobei der Kolbenmantel (184) einen Dichtungssitz (200) an seiner, dem Oberwerkzeug (14, 120) zugewandten, Kolbenoberseite (198) aufweist, in dem ein Flanschbereich (190) des Kolbendichteinsatzes (186) derart eingreift, dass eine umlaufende Dichtungsnut (188) ausgebildet ist, wobei bevorzugt ein Druckkissen (24) auf der Oberseite (182) einen umlaufenden Dichtrand (192) aufweist, der bei einer Druckbeaufschlagung auf den Kolben (30) mit einer sich ausbildenden Dichtnaht (194) in die Dichtungsnut (188) des Kolbens (30) gedrängt wird.

22. Diffusionslötvorrichtung und/oder Sintervorrichtung (10) nach Anspruch 20 oder 21,
wobei der Kolben (30) und das Druckkissen (24) einem Stempel (60, 152) zugeordnet sind, insbesondere ist der Stempel (60, 152) als Softstempel ausgebildet und kann bevorzugt durch das Druckkissen (24) ausgebildet sein, oder der Kolben (30) und das Druckkissen (24) sind einer Mehrzahl von Stempeln (60, 152) zugeordnet.

23. Presswerkzeug (70), ausgebildet als ein Oberwerkzeug (14, 120) oder ein Unterwerkzeug (16, 122) einer Diffusionslötvorrichtung und/oder Sintervorrichtung (10) nach einem der vorhergehenden Ansprüche, umfassend eine starre Grundplatte (72), und, entweder zumindest eine, mit der Grundplatte (72) verbundene, Membran (50, 50A), welche durch eine biegsame, vorzugsweise topfförmig geformte, bevorzugt aus Silikon oder einer Stahllegierung hergestellte Membran (50) gebildet ist, oder eine Vielzahl von Membranabschnitten (50A), in Richtung Pressfläche (92), oder einen Führungsrahmen (40, 154) mit zumindest einem, insbesondere mehrere darin versetzbar führbaren, abgedichteten Stempeln (60, 152), und mit einer Druckkammer, die vorzugsweise zumindest ein mit einem Fluid befülltes Druckkissen (24, 90) beinhaltet, welches in einem abgeschlossenen Aufnahmeraum angeordnet ist, welcher durch die Grundplatte (72) und die Membran (50, 50a) oder den Führungsrahmen (40, 154) mit zumindest einem, insbesondere mehreren abdichtenden Stempeln (60, 152) begrenzt ist, wobei der Führungsrahmen (40, 154) das oder die Druckkissen (24, 90) in Richtung Pressfläche (92) abschließt und den oder die Stempel (60, 152) führt.

24. Presswerkzeug (70) nach Anspruch 23, wobei zumindest ein Teilbereich der Druckkammer, insbesondere ein Teilbereich des Drucckissens (24, 90), steuerbar fluidbefüllbar, insbesondere gasbefüllbar ist, und bevorzugt mittels zumindest eines Füllventils (146) befüllbar ist.

25. Diffusionslötanlage und/oder Sinteranlage umfassend eine Diffusionslötvorrichtung und/oder Sintervorrichtung (10) nach einem der vorgenannten Ansprüche 1 bis 22 und/oder ein Presswerkzeug (70) nach Anspruch 23 oder 24, wobei die Diffusionslötvorrichtung und/oder Sintervorrichtung (10) und/oder das Presswerkzeug (70) in einem atmosphärendichten Modul einer Mehrmodulanlage, insbesondere in einem Vakuummodul, angeordnet ist, wobei zumindest ein weiteres Modul als Vorheiz- und/oder Abkühlmodul vorgesehen ist, und wobei eine Transporteinrichtung vorgesehen ist, die eingerichtet ist, zumindest einen Werkstückträger (18), insbesondere das Unterwerkzeug (16), mit zumindest einer Baugruppe (12) automatisch durch die Mehrmodulanlage zu bewegen, und wobei benachbarte Module der Mehrmodulanlage atmosphärendicht gegeneinander verschließbar sind.

## Claims

1. Diffusion soldering device and/or sintering device (10) for connecting components of at least one electronic assembly (12) by means of diffusion soldering and/or pressure sintering, with an upper tool (14, 120) and a lower tool (16, 122) between which the at least one assembly (12) is held, wherein the upper tool (14, 120) has at least one pressure pad (24, 90) filled or fillable with a fluid or with a displaceable medium whose internal pressure is variable and at least one, in particular several, plungers (60, 152) in operative connection to the pressure pad (24, 90) and configured for transmission of a press force generated by a pressure increase in the pressure pad (24, 90) to the assembly (12), wherein the upper tool (14, 120) has a guide frame (40, 154) in which the plunger(s) (60, 152) is/are guided axially movably along the effective direction of the press force, **whereby** the plunger(s) (60, 152) are guided movably in the guide frame (40, 154) while sealed against the pressure pad (24, 90), whereby the upper tool (14, 120) has at least one pressure unit (20) with a receptacle (22) for the pressure pad (24, 90), **characterized in that** Diffusion soldering device and/or sintering device (10) according to claim 2 or 3, **characterized in that** the pressure unit (20) has a cylinder (28) and a piston (30) movably held therein, wherein the cylinder (28) and the piston (30) define the receptacle (22) for the pressure pad (24, 90) such that the volume of the receptacle (22) is variable by movement of the piston (30).

2. Diffusion soldering device and/or sintering device (10) according to claim 1, **whereby** the pressure unit (20) has an opening (26) facing the lower tool (16, 122) and covered by the guide frame (40, 154), the pressure pad (24, 90) resting on the guide frame (40, 154).

3. Diffusion soldering device and/or sintering device (10) according to claim 2, **whereby** the opening (26) is provided in the piston (30).

4. Diffusion soldering device and/or sintering device (10) according to claim 1 or 3, **whereby** the upper tool (14, 120) and the lower tool (16, 122) are movable relative to one another along the effective direction of the press force, wherein the piston (30) is moved into the cylinder (28) when the upper tool (14, 120) contacts the lower tool (16, 122) or a workpiece carrier resting on the lower tool (16, 122).

5. Diffusion soldering device and/or sintering device (10) according to any of the preceding claims, **whereby** the pressure pad (24, 90) is connected or connectable to a fluid source for supplying fluid into the pressure pad (24, 90), wherein the pressure increase can be effected by the supply of fluid.

6. Diffusion soldering device and/or sintering device (10) according to any of the preceding claims, **whereby** the guide frame (40, 154) comprises a plunger guide plate (46) having guide ducts (42) for axial guidance of the plunger(s) (60, 152).

7. Diffusion soldering device and/or sintering device (10) according to claim 6any of the preceding claims, **cwhereby** at least one flexible membrane (50, 50A) covering the guide ducts (42) is arranged between the pressure pad (24, 90) and the plunger(s) (60, 152).

8. Diffusion soldering device and/or sintering device (10) according to claim 7, **whereby** the guide frame (40, 154) has a membrane holding plate (44) which is arranged on a side of the plunger guide plate (46) facing the pressure pad (24, 90), wherein the membrane (50, 50A) is held between the membrane holding plate (44) and the plunger guide plate (46).

9. Diffusion soldering device and/or sintering device (10) according to claim 8, **whereby** the membrane holding plate (44) has at least one penetration (48) which extends at least over the guide ducts (42).

10. Diffusion soldering device and/or sintering device (10) according to any of claims 7 to 9, **whereby** the plunger(s) (60, 152) is/are permanently or detachably connected to the membrane (50, 50A), preferably bonded.

11. Diffusion soldering device and/or sintering device (10) according to any of claims 6 to 10, **whereby** the upper tool (14, 120) has at least one securing device for the plunger(s) (60, 152) which secures the plunger(s) (60, 152) against dropping out of the guide ducts (42).

12. Diffusion soldering device and/or sintering device (10) according to claims 10 and 11, **whereby** the membrane (50, 50A) is magnetic and that the securing device comprises respective magnetic elements (62) connected to the plunger(s) (60, 152), preferably integrated into the plunger(s) (60, 152), which hold the plunger(s) (60, 152) on the membrane (50, 50A).

13. Diffusion soldering device and/or sintering device (10) according to claim 11 or 12, **whereby** the securing device comprises respective securing pins (66) mounted in the membrane holding plate (44) and extending though recesses (64) provided in the plunger(s) (60, 152).

14. Diffusion soldering device and/or sintering device (10) according to any of claims 6 to 13, **whereby** the plunger(s) (60, 152) are held in the guide ducts (42) with lateral clearance.

15. Diffusion soldering device and/or sintering device (10) according to any of the above claims, **whereby** the plunger(s) (60, 152) can have a square or rectangular cross-section, wherein the guidance sides (162) of the plunger(s) (60, 152) are preferably rounded.

16. Diffusion soldering device and/or sintering device (10) according to claims 6 and 15, **whereby** the guide frame (40, 154), in particular the plunger guide plate (46), has a square or rectangular shape, and the guide ducts (42) have a square or rectangular cross-sectional shape.

17. Diffusion soldering device and/or sintering device (10) according to claim 6, **whereby** one or more guide ducts (42) holds a plurality of closely adjacent plunger(s) (60, 152) that are preferably guidable along each other.

18. Diffusion soldering device and/or sintering device (10) according to any of the above claims, **whereby** the plunger(s) (60, 152) have a sliding guide insert (166) made of a softer material, preferably plastic, than the plunger material on an upper guidance side section (164) facing the pressure pad (24, 90), wherein an all-round plunger groove (174) is provided preferably on the plunger upper side (168) between the upper edge of the sliding guide insert (166) and the plunger upper side (168).

19. Diffusion soldering device and/or sintering device (10) according to any of the above claims, **whereby** the plunger(s) (60, 152) on the plunger underside (170) have a smaller or larger cross-section than on the plunger upper side (168).

20. Diffusion soldering device and/or sintering device (10) according to any of the above claims 1 bis 4, **whereby** the piston (30) is guided movably while sealed against the cylinder (24, 90), wherein the piston (30) is preferably formed as an annular piston (76, 126) and preferably comprises a piston skirt (184) of a harder material, in particular steel, and a piston sealing insert (186) of a softer material, in particular plastic, positively held in the piston skirt (184).

21. Diffusion soldering device and/or sintering device (10) according to claim 20, **whereby** the piston skirt (184) has a sealing seat (200) on its piston upper side (198) facing the upper tool (14, 120), in which seat a flange area (190) of the piston sealing insert (186) engages such that an all-round sealing groove (188) is formed, wherein a pressure pad (24) preferably has on the upper side (182) an all-round sealing edge (192) which, when pressure is applied to the piston (30), can be forced into the sealing groove (188) of the piston (30) with a seal seam (194) being formed.

22. Diffusion soldering device and/or sintering device (10) according to claim 20 or 21, **whereby** the piston (30) and the pressure pad (24) are associated with a plunger (60, 152), in particular the plunger (60, 152) is designed as a soft plunger and can preferably be provided by the pressure pad (24), or the piston (30) and the pressure pad (24) are associated with a plurality of plungers (60, 152).

23. Press tool (70) designed as an upper tool (14, 120) or a lower tool (16, 122) of a diffusion soldering device and/or sintering device (10) according to any of the preceding claims, comprising a rigid baseplate (72) and either at least one membrane (50, 50A) connected to the baseplate (72) which is formed by a flexible, preferably dish-shaped membrane (50) preferably made from silicone or a steel alloy or a plurality of membrane sections (50A), in the direction of the press surface (92), or a guide frame (40, 154) with at least one, in particular several plungers (60, 152) movably guidable therein, and with a pressure chamber preferably comprising at least one pressure pad (24, 90) filled with a fluid and arranged in a closed receiving space limited by the baseplate (72) and the membrane (50, 50A) or the guide frame (40, 154) with at least one, in particular several sealing plungers (60, 152), wherein the guide frame (40, 154) closes the pressure pad(s) (24, 90) in the direction of the press surface (92) and guides the plunger(s) (60, 152).

24. Press tool (70) according to claim 23, **whereby** at least one sub-area of the pressure chamber, in particular a sub-area of the pressure pad (24, 90) is controllably fluid-fillable, in particular gas-fillable, and preferably by means of at least one filler valve (146).

25. Diffusion soldering facility and/or sintering facility comprising a diffusion soldering device and/or sintering device (10) according to any of the above claims 1 to 22 and/or a press tool (70) according to claim 23 or 24, **whereby** the diffusion soldering device and/or sintering device (10) and/or the press tool (70) are arranged in an atmospherically tight module of a multi-module system, in particular in a vacuum module, wherein at least one further module is provided as a preheating and/or cooling module, and wherein a transport device is provided which is configured to automatically move at least one workpiece carrier (18), in particular the lower tool (16), with at least one assembly (12) through the multi-module system, and wherein adjacent modules of the multi-module system are sealable atmospherically tight against one another.

## Revendications

1. Dispositif de brasage par diffusion et/ou dispositif de frittage (10) pour assembler des composants d'au moins un sous-ensemble électronique (12) au moyen de brasage par diffusion et/ou de frittage sous pression, avec un outil supérieur (14, 120) et un outil inférieur (16, 122) entre lesquels est logé ledit au moins un sous-ensemble (12), sachant que l'outil supérieur (14, 120) présente au moins un coussin de pression (24, 90) rempli ou remplissable avec un fluide ou un agent refou-lable, dont la pression intérieure est variable, et au moins un, notamment plusieurs poinçons (60, 152) en liaison fonctionnelle avec le coussin de pression (24, 90), lesquels poinçons sont configurés pour transmettre au sous-ensemble (12) une force de pression générée par une hausse de pression dans le coussin de pression (24, 90), que l'outil supérieur (14, 120) présente un cadre de guidage (40, 154) dans lequel le ou les poinçons (60, 152) sont guidés axialement le long du sens d'action de la force de pression, de manière décalable, que le ou les poinçons (60, 152) sont guidés dans le cadre de guidage (40, 154) de manière décalable et étanchéifiée par rapport au coussin de pression (24, 90), que l'outil supérieur (14, 120) présente au moins une unité de pression (20) avec un logement (22) pour le coussin de pression (24, 90), **caractérisé en ce que** l'unité de pression (20) présente un cylindre (28) et un piston (30) logé à l'intérieur de manière décalable, sachant que le cylindre (28) et le piston (30) définissent le logement (22) pour le coussin de pression (24, 90), que le volume du logement (22) est variable au moyen d'un décalage du piston (30).

2. Dispositif de brasage par diffusion et/ou dispositif de frittage (10) selon la revendication 1, sachant que l'unité de pression (20) présente une ouverture (26) tournée vers l'outil inférieur (16, 122) qui est recouverte par le cadre de guidage (40, 154), sachant que le coussin de pression (24, 90) repose sur le cadre de guidage (40, 154).

3. Dispositif de brasage par diffusion et/ou dispositif de frittage (10) selon la revendication 2, sachant que l'ouverture (26) est prévue dans le piston (30).

4. Dispositif de brasage par diffusion et/ou dispositif de frittage (10) selon la revendication 1 ou 3, sachant que l'outil supérieur (14, 120) et l'outil inférieur (16, 122) sont décalables l'un par rapport à l'autre le long du sens d'action de la force de pression, et que le piston (30) est décalé dans le cylindre (28) par une dépose de l'outil supérieur (14, 120) sur l'outil inférieur (16, 122) ou sur un porte-pièces reposant sur l'outil inférieur (16, 122).

5. Dispositif de brasage par diffusion et/ou dispositif de frittage (10) selon l'une des revendications précédentes, sachant que le coussin de pression (24, 90) est relié ou reliable à une source de fluide pour distribuer du fluide dans le coussin de pression (24, 90), et que la hausse de pression peut être provoquée par la distribution de fluide.

6. Dispositif de brasage par diffusion et/ou dispositif de frittage (10) selon l'une des revendications précédentes, sachant que le cadre de guidage (40, 154) comprend une plaque de guidage des poinçons (46) qui présente des canaux de guidage (42) pour le guidage axial du ou des poinçons (60, 152).

7. Dispositif de brasage par diffusion et/ou dispositif de frittage (10) selon la revendication 6, sachant qu'est disposée entre le coussin de pression (24, 90) et le ou les poinçons (60, 152) au moins une membrane flexible (50, 50A) qui recouvre les canaux de guidage (42).

8. Dispositif de brasage par diffusion et/ou dispositif de frittage (10) selon la revendication 7, sachant que le cadre de guidage (40, 154) présente une plaque de maintien de membrane (44) qui est disposée sur un côté de la plaque de guidage des poinçons (46), tourné vers le coussin de pression (24, 90), et que la membrane (50, 50A) est maintenue entre la plaque de maintien de membrane (44) et la plaque de guidage des poinçons (46).

9. Dispositif de brasage par diffusion et/ou dispositif de frittage (10) selon la revendication 8, sachant que la plaque de maintien de membrane (44) présente au moins une percée (48) qui s'étend au moins au-dessus des canaux de guidage (42).

10. Dispositif de brasage par diffusion et/ou dispositif de frittage (10) selon l'une des revendications 7 à 9, sachant que le ou les poinçons (60, 152) sont reliés, de préférence collés, à la membrane (50, 50A) de manière permanente ou détachable.

11. Dispositif de brasage par diffusion et/ou dispositif de frittage (10) selon l'une des revendications 6 à 10, sachant que l'outil supérieur (14, 120) présente au moins un dispositif de blocage pour le ou les poinçons (60, 152), qui bloque le ou les poinçons (60, 152) pour empêcher une chute du ou des poinçons (60, 152) hors des canaux de guidage (42).

12. Dispositif de brasage par diffusion et/ou dispositif de frittage (10) selon les revendications 10 et 11, sachant que la membrane (50, 50A) est magnétique et que le dispositif de blocage comprend des éléments magnétiques (62) respectifs, reliés au ou aux poinçons (60, 152), de préférence intégrés au ou aux poinçons (60, 152), qui maintiennent le ou les poinçons (60, 152) contre la membrane (50, 50A).

13. Dispositif de brasage par diffusion et/ou dispositif de frittage (10) selon la revendication 11 ou 12, sachant que le dispositif de blocage comprend des broches de blocage (66) respectives qui sont montées dans la plaque de maintien de membrane (44) et s'étendent dans des logements (64) prévus dans le poinçon (60, 152) ou les poinçons (60, 152).

14. Dispositif de brasage par diffusion et/ou dispositif de frittage (10) selon l'une des revendications 6 à 13, sachant que le ou les poinçons (60, 152) sont logés, avec jeu latéral, dans les canaux de guidage (42).

15. Dispositif de brasage par diffusion et/ou dispositif de frittage (10) selon l'une des revendications précédentes, sachant que le ou les poinçons (60, 152) présentent une section carrée ou rectangulaire, sachant que de préférence, les côtés de guidage (162) des poinçons (60, 152) sont arrondis.

16. Dispositif de brasage par diffusion et/ou dispositif de frittage (10) selon les revendications 6 et 15, sachant que le cadre de guidage (40, 154), notamment la plaque de guidage des poinçons (46), possède une forme carrée ou rectangulaire, et que les canaux de guidage (42) présentent une forme de section carrée ou rectangulaire.

17. Dispositif de brasage par diffusion et/ou dispositif de frittage (10) selon la revendication 6, sachant qu'un ou plusieurs canaux de guidage (42) accueillent une pluralité de poinçons voisins (60, 152) qui sont guidables de préférence le long d'eux-mêmes.

18. Dispositif de brasage par diffusion et/ou dispositif de frittage (10) selon l'une des revendications précédentes, sachant que le ou les poinçons (60, 152) présentent, sur une section latérale de guidage (164), supérieure et tournée vers le coussin de pression (24, 90), un insert de guidage coulissant (166) constitué d'un matériau plus tendre que le matériau du poinçon, de préférence constitué de plastique, et que de préférence sur le côté supérieur du poinçon (168), une rainure de poinçon circonférentielle (174) est prévue entre le bord supérieur de l'insert de guidage coulissant (166) et le côté supérieur du poinçon (168).

19. Dispositif de brasage par diffusion et/ou dispositif de frittage (10) selon l'une des revendications précédentes, sachant que le ou les poinçons (60, 152) présentent, sur le côté inférieur du poinçon (170), une section plus petite ou plus grande que sur le côté supérieur du poinçon (168).

20. Dispositif de brasage par diffusion et/ou dispositif de frittage (10) selon l'une des revendications précédentes 1 à 4, sachant que le piston (30) est guidé de manière décalable et étanchéifiée par rapport au cylindre (24, 90), et que, de préférence, le piston (30) est façonné sous forme de piston annulaire (76, 126), et comprend, de préférence, une jupe de piston (184) constituée d'un matériau plus dur, notamment d'acier, et un insert d'étanchéité de piston (186) logé par complémentarité de forme dans la jupe de piston (184) et constitué d'un matériau plus tendre, notamment de plastique.

21. Dispositif de brasage par diffusion et/ou dispositif de frittage (10) selon la revendication 20, sachant que la jupe de piston (184) présente un siège d'étanchéité (200) sur son côté supérieur du piston (198) tourné vers l'outil supérieur (14, 120), dans lequel une zone de bride (190) de l'insert d'étanchéité de piston (186) s'engage de telle sorte qu'une rainure d'étanchéité circonférentielle (188) est constituée, et que de préférence, un coussin de pression (24) présente, sur le côté supérieur (182), un bord d'étanchéité circonférentiel (192) qui est repoussé dans la rainure d'étanchéité (188) du piston (30) en formant un cordon d'étanchéité (194), par l'application d'une pression sur le piston (30).

22. Dispositif de brasage par diffusion et/ou dispositif de frittage (10) selon la revendication 20 ou 21, sachant que le piston (30) ou le coussin de pression (24) est attribué à un poinçon (60, 152), notamment que le poinçon (60, 152) est conçu sous forme de poinçon souple et peut être constitué de préférence par le coussin de pression (24), ou que le piston (30) et le coussin de pression (24) sont attribués à une pluralité de poinçons (60, 152).

23. Outil de compression (70), constitué sous la forme d'un outil supérieur (14, 120) ou d'un outil inférieur (16, 122) d'un dispositif de brasage par diffusion et/ou dispositif de frittage (10) selon l'une des revendications précédentes, comprenant une plaque de base rigide (72) et, soit au moins une membrane (50, 50A) reliée à la plaque de base (72), qui est formée par une membrane (50) souple, de préférence en forme de pot, fabriquée de préférence en silicone ou en un alliage d'acier, ou une pluralité de sections de membrane (50A), en direction de la surface de pression (92), ou un cadre de guidage (40, 154) avec au moins un, notamment plusieurs poinçons (60, 152) étanchéifiés, guidables de manière décalable dedans, et avec une chambre de pression qui contient de préférence au moins un coussin de pression (24, 90) rempli d'un fluide, qui est disposé dans un espace de logement fermé, lequel est limité par la plaque de base (72) et la membrane (50, 50a) ou le cadre de guidage (40, 154) avec au moins un, notamment plusieurs poinçons (60, 152) étanchéifiants, sachant que le cadre de guidage (40, 154) termine le ou les coussins de pression (24, 90) en direction de la surface de pression (92) et guide le ou les poinçons (60, 152).

24. Outil de compression (70) selon la revendication 23, sachant qu'au moins une zone partielle de la chambre de pression, notamment une zone partielle du coussin de pression (24, 90) peut être remplie de fluide, notamment de gaz, de manière pilotable, et peut être remplie de préférence au moyen d'au moins une soupape de remplissage (146).

25. Installation de brasage par diffusion et/ou de frittage comprenant un dispositif de brasage par diffusion et/ou dispositif de frittage (10) selon l'une des revendications 1 à 22 et/ou un outil de compression (70) selon la revendication 23 ou 24, sachant que le dispositif de brasage par diffusion et/ou dispositif de frittage (10) et/ou l'outil de compression (70) est disposé dans un module étanche à l'atmosphère, d'une installation à plusieurs modules, notamment dans un module sous vide, sachant qu'au moins un autre module est prévu comme module de préchauffe et/ou de refroidissement, et sachant qu'est prévu un dispositif de transport qui est configuré pour déplacer au moins un porte-pièces (18), notamment l'outil inférieur (16), avec au moins un sous-ensemble (12), de manière automatique à travers l'installation à plusieurs modules, et sachant que des modules voisins de l'installation à plusieurs modules sont obturables les uns des autres de manière à être étanches à l'atmosphère.
